# EUROPEAN PATENT APPLICATION

(11) **EP 4 776 823 A1**
(43) Date of publication of application: **15.07.2026**
(21) Application number: 23951495.3
(22) Date of filing: 06.09.2023
(51) Int. Cl.: H10N 60/12

(54) **QUANTUM DEVICE, METHOD FOR MANUFACTURING QUANTUM DEVICE, AND METHOD FOR INSPECTING QUANTUM DEVICE**

(71) Applicant: FUJITSU LIMITED, Kawasaki-shi, Kanagawa 211-8588 (JP)
(72) Inventor: KAWANO, Hiroyasu, Kawasaki-shi, Kanagawa 211-8588 (JP)
(74) Representative: Haseltine Lake Kempner LLP
(86) International application number: PCT/JP2023/032563
(87) International publication number: WO 2025/052597

(57) **Abstract**

A quantum device includes a first Josephson junction element formed on a substrate; a second Josephson junction element; and a first temperature sensing structure, the second Josephson junction element and the first temperature sensing structure being formed in a first region of the substrate, wherein the first Josephson junction element includes a first superconducting film; a second superconducting film; and a first oxide film provided between the first superconducting film and the second superconducting film, the second Josephson junction element includes a third superconducting film; a fourth superconducting film; and a second oxide film provided between the third superconducting film and the fourth superconducting film, and wherein the first temperature sensing structure is irreversibly deformed at a first temperature that is lower than a temperature at which a superconducting characteristic of the third superconducting film or the fourth superconducting film changes. The quantum device can be used for quantum computing, for example.

## Description

### FIELD

The present disclosure relates to quantum device, a method of manufacturing a quantum device, and a method of inspecting a quantum device.

### BACKGROUND

A quantum device having a quantum bit including a Josephson junction element is used in a quantum computer in some cases. A quantum bit including a Josephson junction element is referred to as a transmon in some cases. A quantum bit including a Josephson junction element has a resonance frequency, and the resonance frequency changes according to a resistance value of the Josephson junction element. Further, most of the resistance value of the Josephson junction element is the resistance value of the oxide film included in the Josephson junction element. Therefore, a technique for accurately adjusting the resistance value of the oxide film, for example, the resistance value of the oxide film at room temperature, to a predetermined value has been studied. For example, as a method for adjusting the resistance value of the oxide film, a method for forming a Josephson junction element in which the resistance value of the oxide film is lower than a predetermined value and increasing the degree of oxidation of the oxide film by irradiation with laser beam has been proposed.

Patent Document 1: U.S. Patent Application No. 2022/0140221
Patent Document 2: U.S. Patent Application No. 2019/0165246
Patent Document 3: Japanese Laid-open Patent Publication No. 2003-031862
Patent Document 4: Japanese Laid-open Patent Publication No. 2015-192071

### SUMMARY OF INVENTION

### TECHNICAL PROBLEM

Even when the resistance value of the oxide film is adjusted to a predetermined value by irradiation with the laser beam, the Josephson junction element is exposed to an excessively high temperature by irradiation with the laser beam, and the superconducting characteristics of the Josephson junction element may change. When the superconducting characteristics of the Josephson junction element change, the characteristics of the quantum bit also change. Therefore, it is desired to identify a temperature level to which the Josephson junction element is exposed by irradiation with the laser beam. However, it is conventionally difficult to identify a temperature level to which the Josephson junction element is exposed by irradiation with the laser beam.

An object of the present disclosure is to provide a quantum device capable of identifying a temperature level to which the Josephson junction element is exposed by irradiation with the laser beam, a method of manufacturing the quantum device, and a method of inspecting the quantum device.

### SUMMARY

According to one aspect of the present disclosure, there is provided a quantum device includes a first Josephson junction element formed on a substrate; a second Josephson junction element; and a first temperature sensing structure, the second Josephson junction element and the first temperature sensing structure being formed in a first region of the substrate, wherein the first Josephson junction element includes a first superconducting film; a second superconducting film; and a first oxide film provided between the first superconducting film and the second superconducting film, the second Josephson junction element includes a third superconducting film; a fourth superconducting film; and a second oxide film provided between the third superconducting film and the fourth superconducting film, and wherein the first temperature sensing structure is irreversibly deformed at a first temperature that is lower than a temperature at which a superconducting characteristic of the third superconducting film or the fourth superconducting film changes.

### ADVANTAGEOUS EFFECTS OF INVENTION

According to the present disclosure, it is possible to identify a temperature level to which a Josephson junction element is exposed by irradiation with a laser beam.

### BRIEF DESCRIPTION OF THE DRAWINGS

[FIG. 1] FIG. 1 is a diagram illustrating a layout of a quantum device according to a first embodiment.
[FIG. 2] FIG. 2 is a circuit diagram illustrating a circuit included in a functional region.
[FIG. 3] FIG. 3 is a plan view illustrating a configuration of a functional region.
[FIG. 4] FIG. 4 is a plan view illustrating the configuration of a test region.
[FIG. 5] FIG. 5 is a cross-sectional view illustrating the configuration of a functional region and a test region.
[FIG. 6] FIG. 6 is a flowchart illustrating a method of manufacturing a quantum device according to a first embodiment.
[FIG. 7] FIG. 7 is a plan view (part 1) illustrating a method of manufacturing a quantum device according to a first embodiment.
[FIG. 8] FIG. 8 is a plan view (part 2) illustrating a method of manufacturing a quantum device according to a first embodiment.
[FIG. 9] FIG. 9 is a plan view (part 3) illustrating a method of manufacturing a quantum device according to a first embodiment.
[FIG. 10] FIG. 10 is a plan view (part 4) illustrating a method of manufacturing a quantum device according to the first embodiment.
[FIG. 11] FIG. 11 is a plan view (part 5) illustrating a method of manufacturing a quantum device according to the first embodiment.
[FIG. 12] FIG. 12 is a plan view (part 6) illustrating a method of manufacturing a quantum device according to the first embodiment.
[FIG. 13] FIG. 13 is a plan view (part 7) illustrating a method of manufacturing a quantum device according to the first embodiment.
[FIG. 14] FIG. 14 is a plan view (part 8) illustrating a method of manufacturing a quantum device according to the first embodiment.
[FIG. 15] FIG. 15 is a cross-sectional view (part 1) illustrating a method of manufacturing a quantum device according to the first embodiment.
[FIG. 16] FIG. 16 is a cross-sectional view (part 2) illustrating a method of manufacturing a quantum device according to the first embodiment.
[FIG. 17] FIG. 17 is a cross-sectional view (part 3) illustrating a method of manufacturing a quantum device according to the first embodiment.
[FIG. 18] FIG. 18 is a cross-sectional view (part 4) illustrating a method of manufacturing a quantum device according to the first embodiment.
[FIG. 19] FIG. 19 is a cross-sectional view (part 5) illustrating a method of manufacturing a quantum device according to the first embodiment.
[FIG. 20] FIG. 20 is a cross-sectional view (part 6) illustrating a method of manufacturing a quantum device according to the first embodiment.
[FIG. 21] FIG. 21 is a cross-sectional view (part 7) illustrating a method of manufacturing a quantum device according to the first embodiment.
[FIG. 22] FIG. 22 is a plan view illustrating a temperature sensing structure included in a quantum device according to the second embodiment.
[FIG. 23] FIG. 23 is a plan view (part 1) illustrating a method of forming a metal film according to the second embodiment.
[FIG. 24] FIG. 24 is a plan view (part 2) illustrating a method of forming a metal film according to the second embodiment.
[FIG. 25] FIG. 25 is a plan view (part 3) illustrating a method of forming a metal film according to the second embodiment.
[FIG. 26] FIG. 26 is a plan view illustrating a temperature sensing structure included in a quantum device according to the third embodiment.
[FIG. 27] FIG. 27 is a plan view (part 1) illustrating a method of forming a metal film according to the third embodiment.
[FIG. 28] FIG. 28 is a plan view (part 2) illustrating a method of forming a metal film according to the third embodiment.
[FIG. 29] FIG. 29 is a plan view illustrating a temperature sensing structure included in a quantum device according to the fourth embodiment.
[FIG. 30] FIG. 30 is a plan view (part 1) illustrating a method of forming a metal film according to the fourth embodiment.
[FIG. 31] FIG. 31 is a plan view (part 2) illustrating a method of forming a metal film according to the fourth embodiment.
[FIG. 32] FIG. 32 is a plan view (part 3) illustrating a method of forming a metal film according to the fourth embodiment.
[FIG. 33] FIG. 33 is a plan view (part 4) illustrating a method of forming a metal film according to the fourth embodiment.
[FIG. 34] FIG. 34 is a plan view (part 5) illustrating a method of forming a metal film according to the fourth embodiment.
[FIG. 35] FIG. 35 is a plan view illustrating a temperature sensing structure included in a quantum device according to the fourth embodiment.
[FIG. 36] FIG. 36 is a cross-sectional diagram illustrating a temperature sensing structure included in a quantum device according to the fourth embodiment.
[FIG. 37] FIG. 37 is a diagram (part 1) illustrating a method of forming a metal film according to the fifth embodiment.
[FIG. 38] FIG. 38 is a diagram (part 2) illustrating a method of forming a metal film according to the fifth embodiment.
[FIG. 39] FIG. 39 is a diagram (part 3) illustrating a method of forming a metal film according to the fifth embodiment.
[FIG. 40] FIG. 40 is a diagram illustrating a layout of a quantum device according to the sixth embodiment.
[FIG. 41] FIG. 41 is a diagram illustrating a layout of a quantum device according to the seventh embodiment.
[FIG. 42] FIG. 42 is a diagram illustrating a layout of a quantum device according to the eighth embodiment.

### DESCRIPTION OF EMBODIMENTS

Hereinafter, embodiments of the present disclosure will be specifically described with reference to the accompanying drawings. In the present specification and the drawings, components having substantially the same functional configuration may be given the same reference numerals, thereby eliminating redundant descriptions. In the present disclosure, the X1-X2 direction, the Y1-Y2 direction, and the Z1-Z2 direction are mutually orthogonal directions. A plane including the X1-X2 direction and the Y1-Y2 direction will be referred to as an XY plane, a plane including the Y1-Y2 direction and the Z1-Z2 direction will be referred to as a YZ plane, and a plane including the Z1-Z2 direction and the X1-X2 direction will be referred to as a ZX plane. For convenience, the Z1-Z2 direction is a vertical direction, the Z1 side is an upper side, and the Z2 side is a lower side. Further, a plan view means that the object is viewed from the Z1 side, and a plan shape means a shape of the object viewed from the Z1 side.

### (First Embodiment)

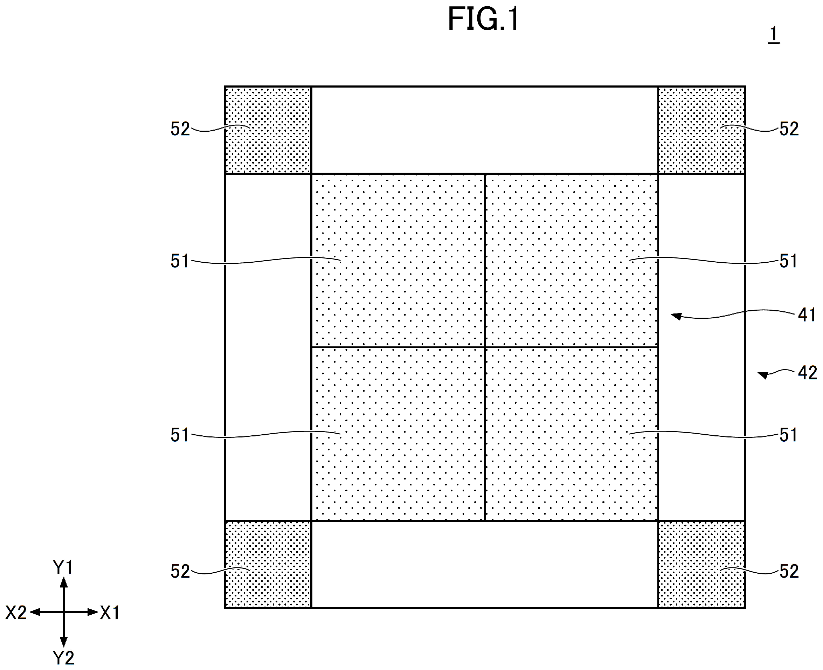

A first embodiment will be described. A first embodiment relates to a quantum device. FIG. 1 is a diagram illustrating a layout of a quantum device according to a first embodiment.

As illustrated in FIG. 1, a quantum device 1 according to a first embodiment has a center region 41 and a peripheral region 42. In a plan view, the center region 41 is surrounded by the peripheral region 42. The center region 41 has, for example, four functional regions 51. For example, the functional regions 51 have a square planar shape, and two functional regions are arranged side by side in the X1 - X2 direction and the Y1 - Y2 direction. The peripheral region 42 has, for example, the same number of test regions 52 as the functional regions 51. For example, the test regions 52 are arranged at 4 corners of the peripheral region 42.

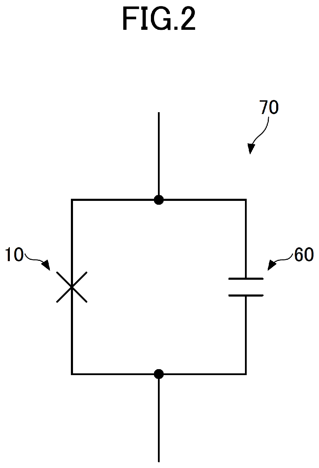

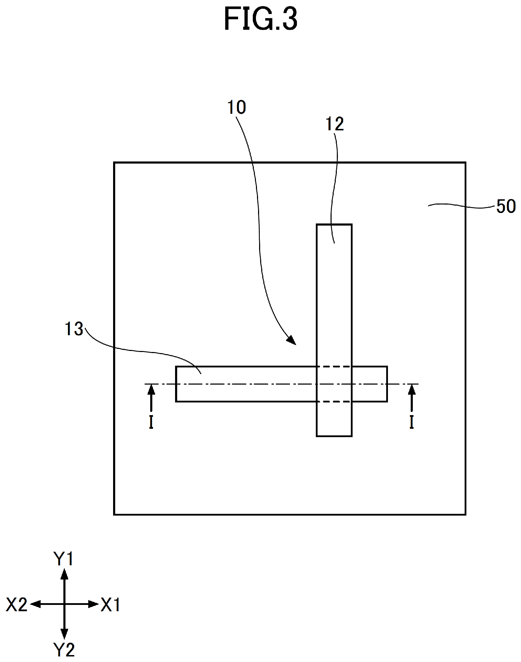

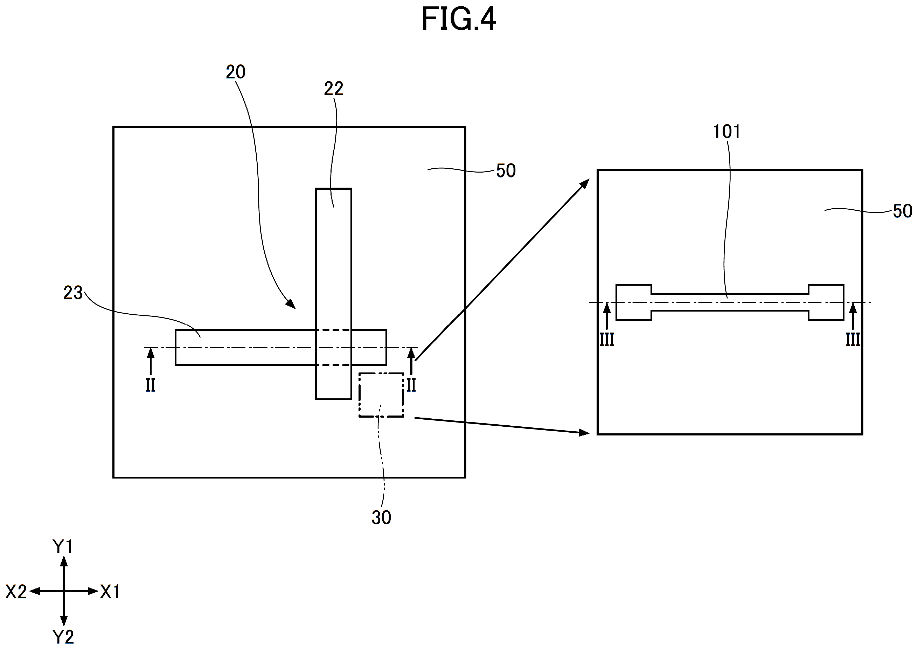

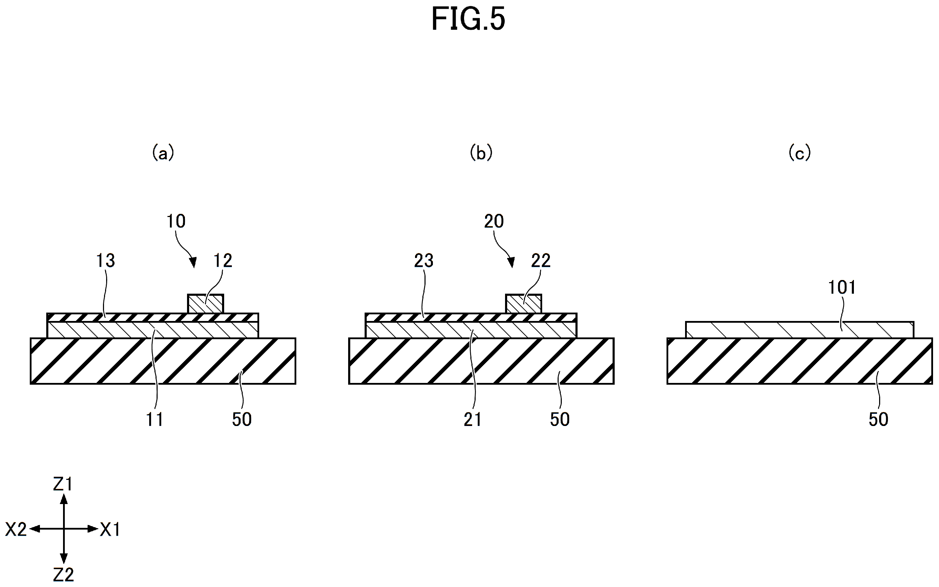

The functional region 51 and the test region 52 will now be described. FIG. 2 is a circuit diagram illustrating a circuit included in the functional region 51. FIG. 3 is a plan view illustrating a configuration of the functional region 51. FIG. 4 is a plan view illustrating a configuration of the test region 52. FIG. 5 is a cross-sectional view illustrating a configuration of the functional region 51 and the test region 52.

As illustrated in FIG. 2, the functional region 51 has a Josephson junction element 10 and a capacitor 60. The Josephson junction element 10 and the capacitor 60 are connected in parallel with each other, and a transmon 70 is formed from the Josephson junction element 10 and the capacitor 60. The transmon 70 is an example of a circuit.

As illustrated in FIGS. 3 to 5, the quantum device 1 has a substrate 50. The substrate 50 is, for example, a silicon substrate. FIG. 5 illustrates a cross section along the I-I line in FIG. 3, a cross section along the II-II line in FIG. 4, and a cross section along the III-III line in FIG. 4. FIG. 5 (a) illustrates a cross section along the I-I line in FIG. 3, FIG. 5 (b) illustrates a cross section along the II-II line in FIG. 4, and FIG. 5 (c) illustrates a cross section along the III-III line in FIG. 4.

As illustrated in FIGS. 3 and 5, the functional region 51 has a lower superconducting film 11, an upper superconducting film 12, and an oxide film 13. The lower superconducting film 11 and the upper superconducting film 12 are provided on the substrate 50. The lower superconducting film 11 has a portion extending in parallel with the X1-X2 direction. The lower superconducting film 11 is, for example, an aluminum film. The oxide film 13 is provided on the upper surface of the lower superconducting film 11 and covers the upper surface of the lower superconducting film 11. The oxide film 13 is, for example, an aluminum oxide film. The upper superconducting film 12 extends in parallel with the Y1-Y2 direction and has a portion intersecting a portion of the lower superconducting film 11 extending in parallel with the X1-X2 direction in a plan view. The upper superconducting film 12 is, for example, an aluminum film or a niobium film. In a portion where the lower superconducting film 11 and the upper superconducting film 12 intersect each other in a plan view, the upper superconducting film 12 is provided on the oxide film 13. The oxide film 13 is provided between the lower superconducting film 11 and the upper superconducting film 12. The lower superconducting film 11 contacts the lower surface of the oxide film 13, and the lower surface of the upper superconducting film 12 contacts the upper surface of the oxide film 13. A portion where the lower superconducting film 11, the oxide film 13 and the upper superconducting film 12 overlap functions as a Josephson junction element 10. The Josephson junction element 10 is an example of a first Josephson junction element. The lower superconducting film 11 is an example of a first superconducting film, the upper superconducting film 12 is an example of a second superconducting film, and the oxide film 13 is an example of a first oxide film.

As illustrated in FIGS. 4 and 5, the test region 52 includes a lower superconducting film 21, an upper superconducting film 22, and an oxide film 23. The lower superconducting film 21 and the upper superconducting film 22 are provided on the substrate 50. The lower superconducting film 21 has a portion extending parallel with the X1-X2 direction. The lower superconducting film 21 is, for example, an aluminum film. The oxide film 23 is provided on the upper surface of the lower superconducting film 21 and covers the upper surface of the lower superconducting film 21. The oxide film 23 is, for example, an aluminum oxide film. The upper superconducting film 22 extends in parallel with the Y1-Y2 direction and has a portion that intersects a portion of the lower superconducting film 21 that extends in parallel with the X1-X2 direction in a plan view. The upper superconducting film 22 is, for example, an aluminum film or a niobium film. In a portion where the lower superconducting film 21 and the upper superconducting film 22 intersect each other in a plan view, the upper superconducting film 22 is provided on the oxide film 23. The oxide film 23 is provided between the lower superconducting film 21 and the upper superconducting film 22. The lower superconducting film 21 contacts the lower surface of the oxide film 23, and the upper surface of the oxide film 23 contacts the lower surface of the upper superconducting film 22. A portion where the lower superconducting film 21, the oxide film 23 and the upper superconducting film 22 overlap functions as a Josephson junction element 20. The Josephson junction element 20 is an example of a second Josephson junction element. The lower superconducting film 21 is an example of a third superconducting film, the upper superconducting film 22 is an example of a fourth superconducting film, and the oxide film 23 is an example of a second oxide film. The test region 52 is an example of a first region.

The thickness of the oxide film 13 and the thickness of the oxide film 23 are substantially equal to each other. For example, the thickness of the oxide film 23 is 99% or more and 101% or less of the thickness of the oxide film 13.

As illustrated in FIGS. 3 and 4, the test region 52 includes a temperature sensing region 30. The temperature sensing region 30 is arranged closer to the Josephson junction element 20 than to the Josephson junction element 10. A metal film 101 is provided in the temperature sensing region 30. The metal film 101 is provided near the Josephson junction element 20 in a plan view. The metal film 101 has, for example, the shape of a thin line extending in parallel with the X1-X2 direction. The dimension (thickness) of the metal film 101 in the Z1-Z2 direction is, for example, 0.1 or more µm and 1.0 µm or less. The dimension (width) of the narrowest portion of the metal film 101 in the Y1-Y2 direction is, for example, 1 µm or more and 10 µm or less. As described later, the Josephson junction element 20 is irradiated with a laser beam. The first distance between the metal film 101 and the Josephson junction element 20 is less than or is equal to the radius of a spot of the laser beam radiated to the Josephson junction element 20, and is, for example, 100 µm or less. The first distance is preferably 80 µm or less, and more preferably 60 µm or less. Here, the first distance between the metal film 101 and the Josephson junction element 20 is a distance between a point of the metal film 101 farthest from the Josephson junction element 20 and a point of the Josephson junction element 20 farthest from the metal film 101.

The metal film 101 is irreversibly deformed at a first temperature lower than the temperature (e.g., 200 °C) at which the superconducting characteristics of the lower superconducting film 21 or the upper superconducting film 22 change. For example, the temperature at which the superconducting characteristics of the lower superconducting film 21 change is the temperature at which the lower superconducting film 21 recrystallizes, and the temperature at which the superconducting characteristics of the upper superconducting film 22 change is the temperature at which the upper superconducting film 22 recrystallizes. The material of the metal film 101 is, for example, a tin (Sn) - lead (Pb) alloy or a bismuth (Bi) - tin (Sn) alloy, and the melting point of the metal film 101 is, for example, 190 °C. When the laser beam is radiated, the temperature of the metal film 101 is approximately the same as the temperature of a portion (temporary JJ element) to be the Josephson junction element 20. Therefore, when the temperature of the temporary JJ element becomes higher than the melting point of the metal film 101 when the laser beam is radiated, the metal film 101 melts and irreversibly deforms. Therefore, the resistance value of the metal film 101 changes. For example, the resistance value between both ends of the metal film 101 in the X1-X2 direction changes. Depending on the degree of deformation, disconnection may occur between both ends of the metal film 101 in the X1-X2 direction. The melting point of the metal film 101 is lower than the temperature at which the superconducting characteristics of the lower superconducting film 21 or the upper superconducting film 22 change, for example, 140 °C or more and 190 °C or less. The melting point of the metal film 101 may be 140 °C or more and 180 °C or less. The metal film 101 is an example of the first temperature sensing structure.

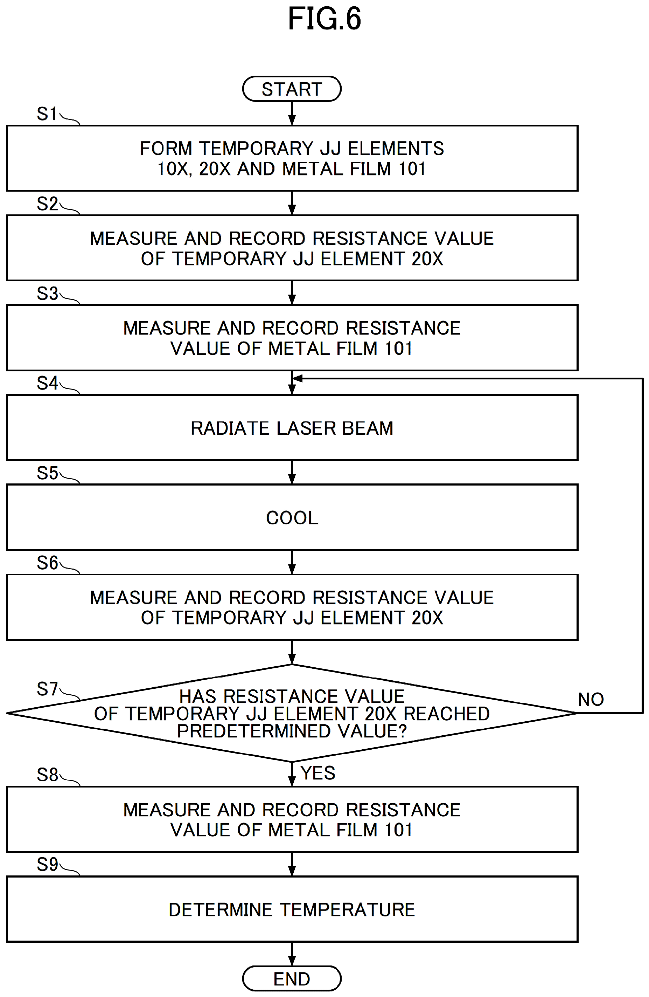

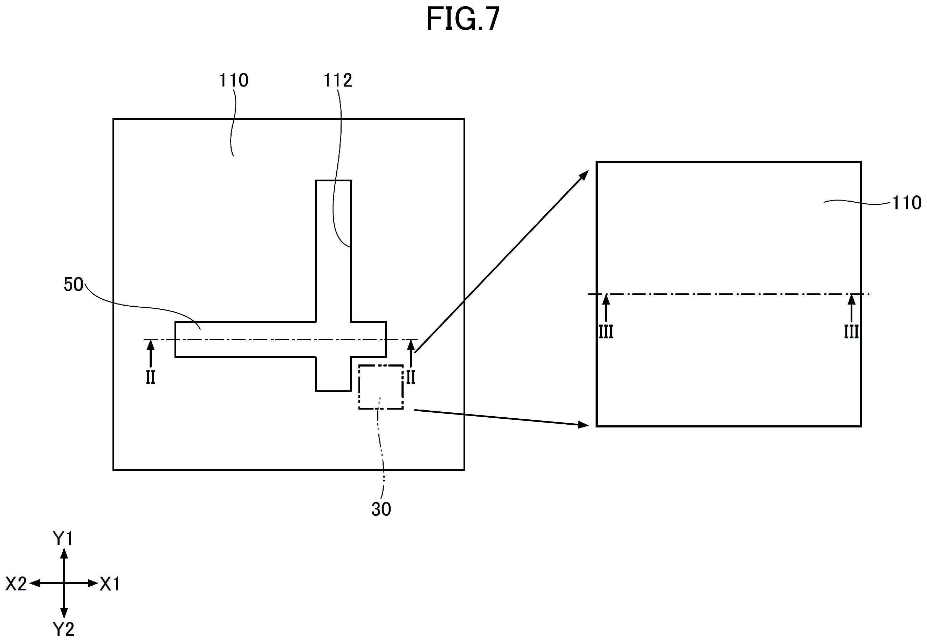

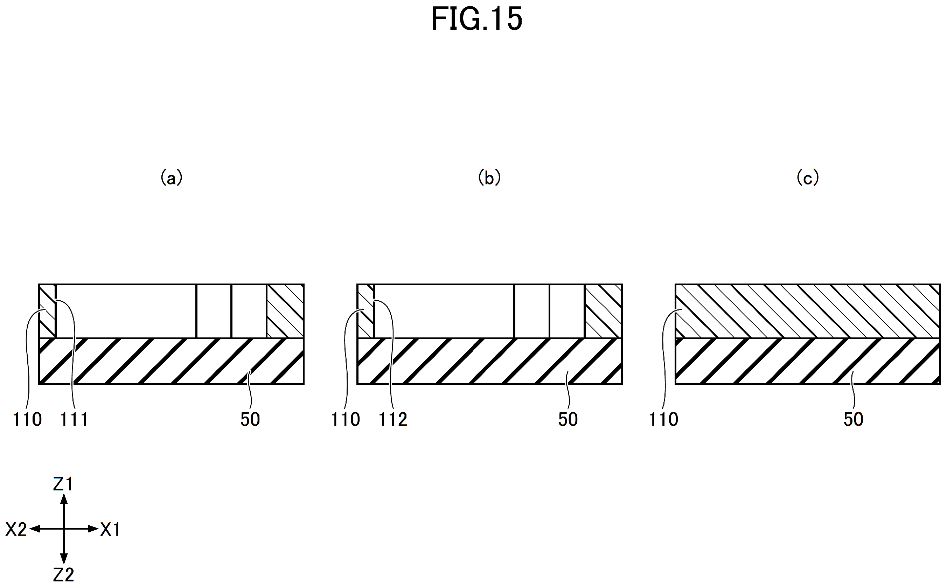

Next, a method of manufacturing the quantum device 1 according to the first embodiment will be described. FIG. 6 is a flowchart illustrating a method of manufacturing the quantum device 1 according to the first embodiment. FIGS. 7 to 14 are plan diagrams illustrating a method of manufacturing the quantum device 1 according to the first embodiment. FIGS. 15 to 21 are cross-sectional diagrams illustrating a method of manufacturing the quantum device 1 according to the first embodiment. FIGS. 15 to 21 illustrate changes in the cross section along the line I-I in FIG. 3, changes in the cross section along the line II-II in FIG. 4, and changes in the cross section along the line III-III in FIG. 4. FIGS. 15 (a) to 21 (a) illustrate a cross section along the line I-I in FIG. 3, FIGS. 15 (b) to 21 (b) illustrate a cross section along the line II-II in FIG. 4, and FIGS. 15 (c) to 21 (c) illustrate a cross section along the line III-III in FIG. 4.

First, a temporary Josephson junction element (JJ element) 10X to be a Josephson junction element 10, a temporary JJ element 20X to be a Josephson junction element 20, and a metal film 101 are formed (step S1). The metal film 101 may be formed after the temporary JJ elements 10X and 20X are formed, or the temporary JJ elements 10X and 20X may be formed after the metal film 101 is formed. Here, a method of forming the metal film 101 after the temporary JJ elements 10X and 20X are formed will be described.

As illustrated in FIGS. 7 and 15, a mask 110 having openings 111 and 112 is formed on the substrate 50. A region for forming the lower superconducting film 11 and a region for forming the upper superconducting film 12 of the substrate 50 are exposed from the opening 111. A region for forming the lower superconducting film 21 and a region for forming the upper superconducting film 22 of the substrate 50 are exposed from the opening 112. In the formation of the mask 110, a photoresist is applied on the substrate 50, and then exposure and development of the photoresist are performed.

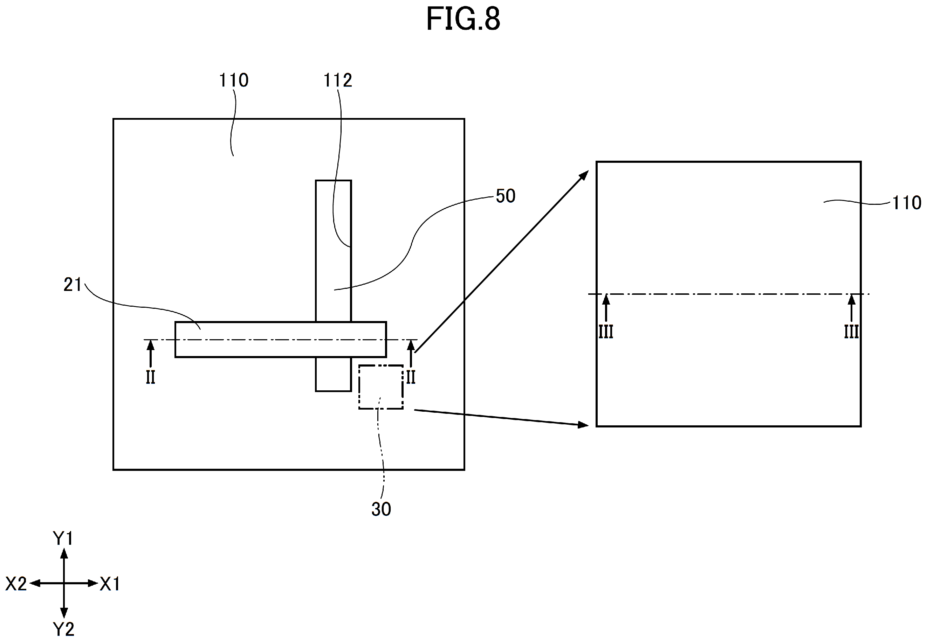

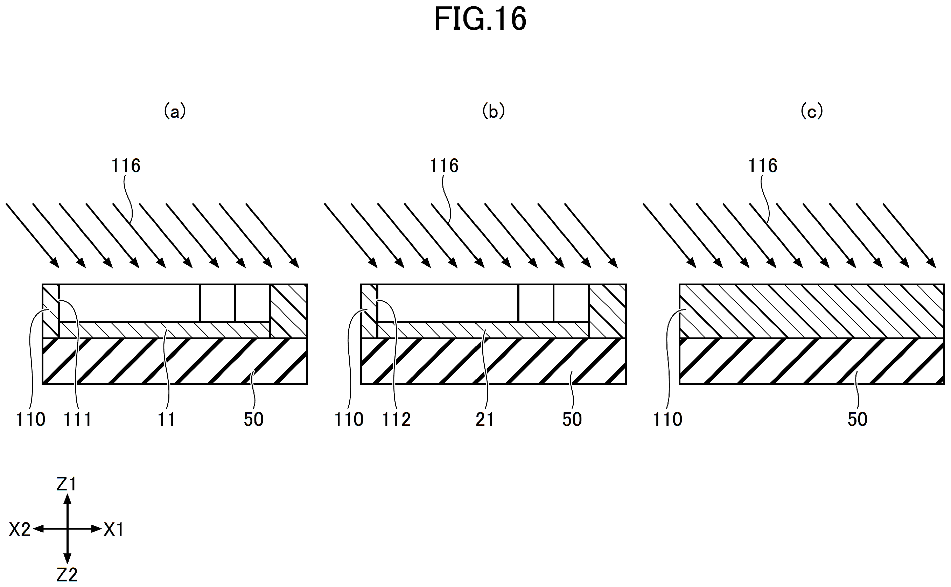

Next, as illustrated in FIGS. 8 and 16, oblique deposition 116 of aluminum is performed at an angle tilted from the Z1 side toward the X2 side when viewed from the top surface of the substrate 50. As a result, the lower superconducting film 11 is formed on the substrate 50 in the opening 111, and the lower superconducting film 21 is formed on the substrate 50 in the opening 112. The oblique deposition 116 may be performed in a direction inclined from the Z1 side to the X1 side as seen from the top surface of the substrate 50.

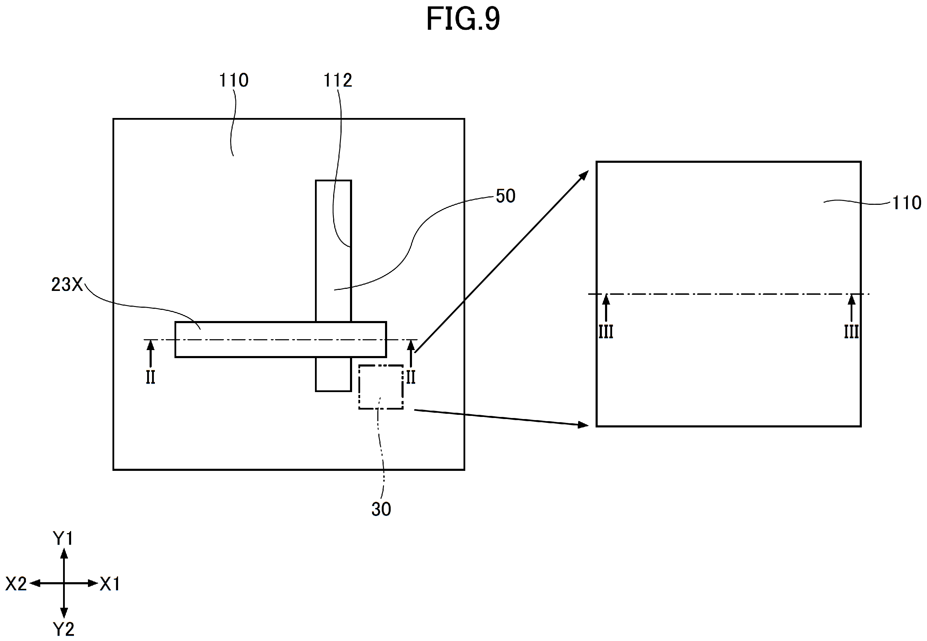

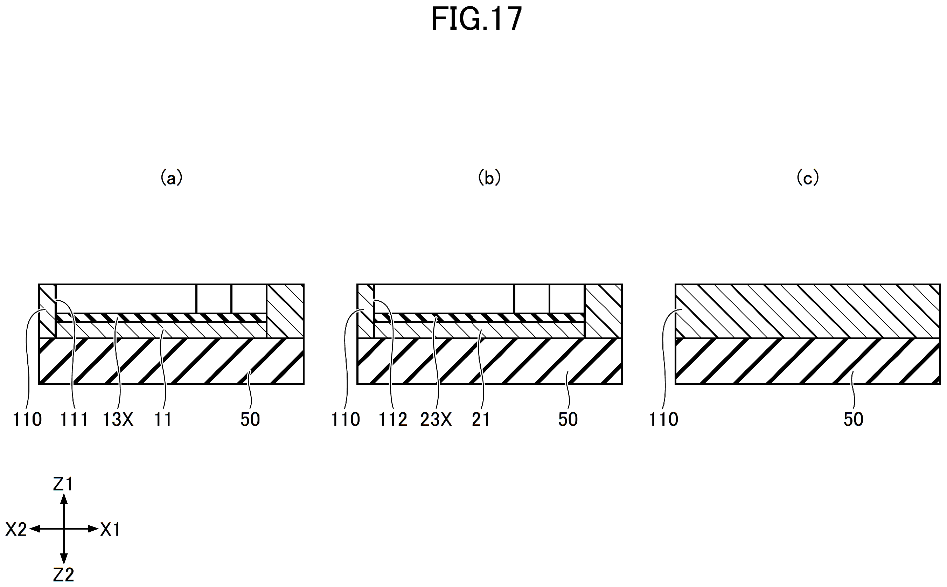

Thereafter, the top surface of the lower superconducting film 11 and the top surface of the lower superconducting film 21 are oxidized. In the oxidation of the top surface of the lower superconducting film 11 and the top surface of the lower superconducting film 21, for example, the atmosphere in the deposition tank in which the lower superconducting film 11 and the lower superconducting film 21 are formed is made to be an oxygen atmosphere, and the top surface of the lower superconducting film 11 and the top surface of the lower superconducting film 21 are exposed to the oxygen atmosphere for several minutes to several tens of minutes. As a result, as illustrated in FIGS. 9 and 17, the oxide film 13X is formed on the top surface of the lower superconducting film 11, and the oxide film 23X is formed on the top surface of the lower superconducting film 21.

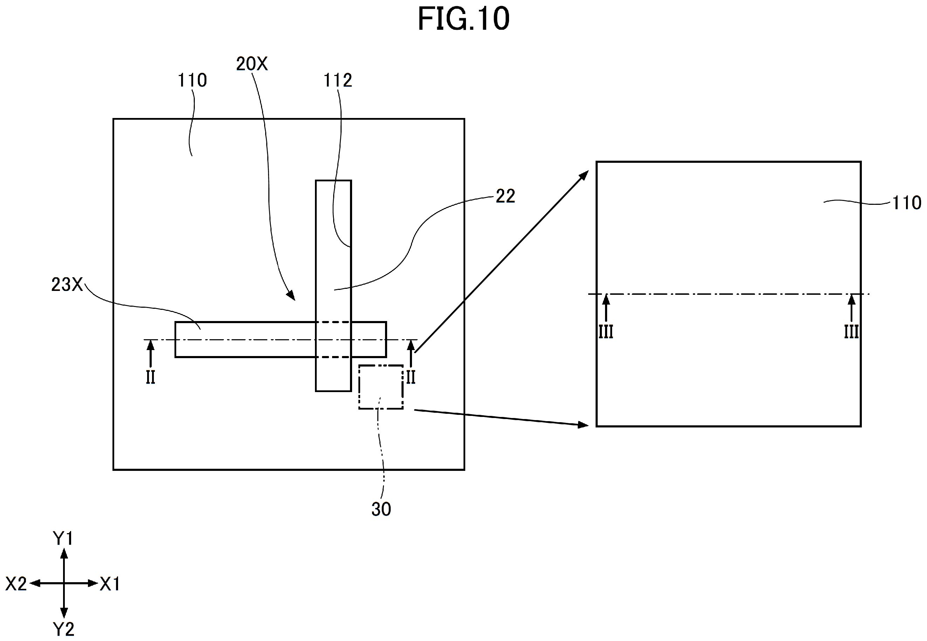

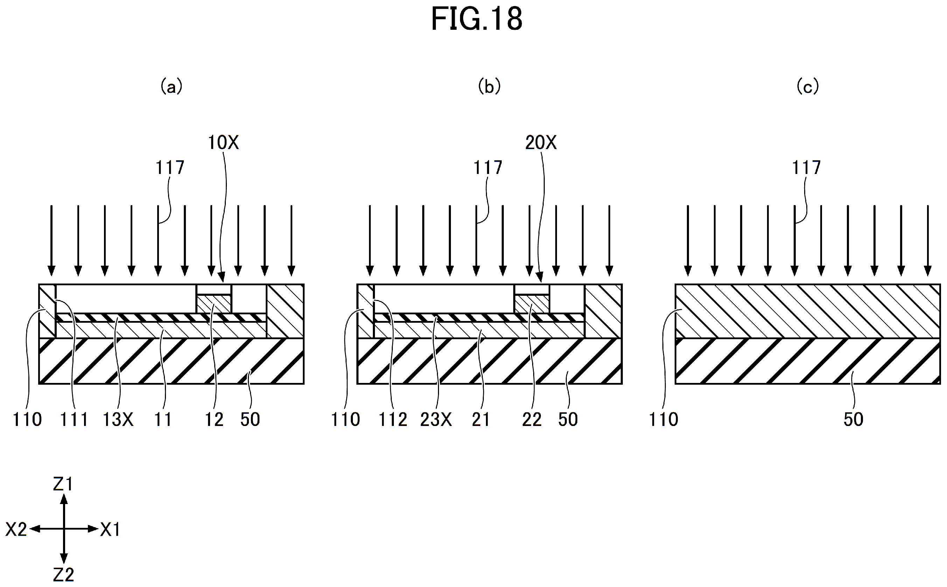

Subsequently, as illustrated in FIGS. 10 and 18, the oblique deposition 117 of aluminum or niobium is performed at an angle tilted from the Z1 side toward the Y1 side when viewed from the top surface of the substrate 50. As a result, the upper superconducting film 12 is formed on the substrate 50 and the oxide film 13X in the opening 111, and the upper superconducting film 22 is formed on the substrate 50 and the oxide film 24X in the opening 112. The oblique deposition 117 may be performed in a direction inclined from the Z1 side to the Y2 side when viewed from the top surface of the substrate 50. The upper superconducting films 12 and 22 can be formed, for example, in a deposition tank in which oxide films 13X and 23X are formed. With the formation of the upper superconducting films 12 and 22, a temporary JJ element 10X including the lower superconducting film 11, the oxide film 13X and the upper superconducting film 12 and a temporary JJ element 20X including the lower superconducting film 21, the oxide film 23X and the upper superconducting film 22 are obtained. The temporary JJ element 10X is an example of the first temporary Josephson junction element, and the temporary JJ element 20X is an example of the second temporary Josephson junction element.

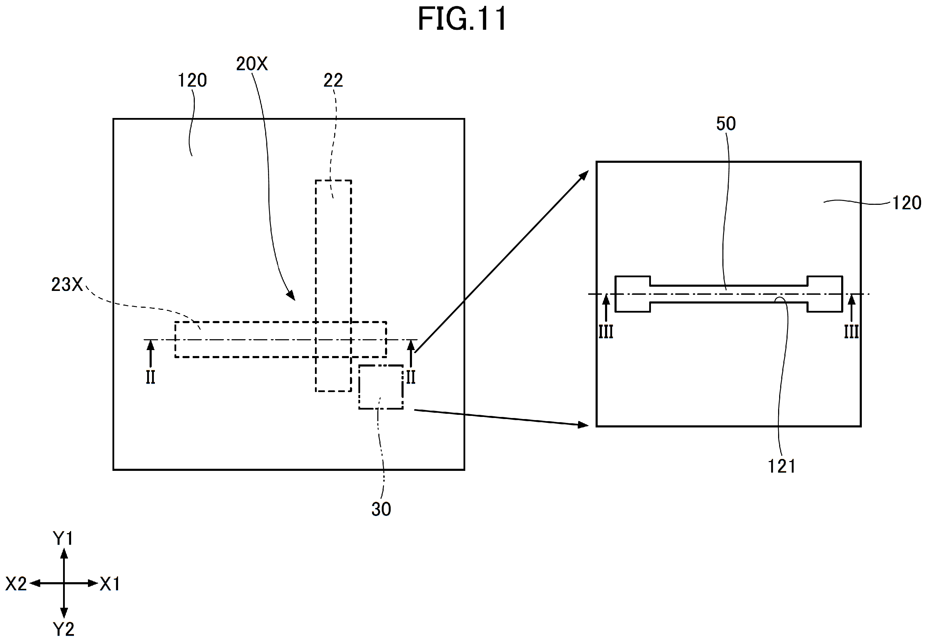

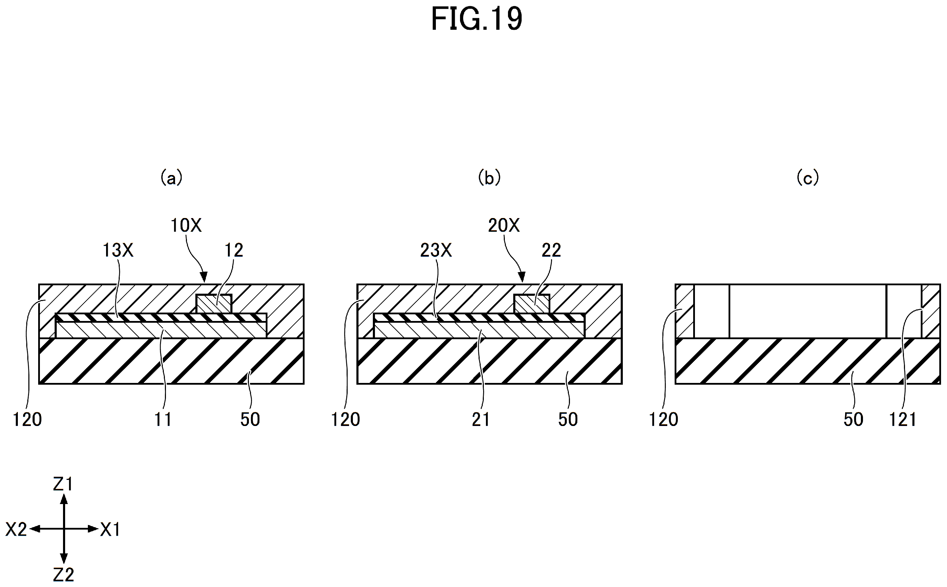

Next, as illustrated in FIGS. 11 and 19, the mask 110 is removed. The mask 110 can be removed by immersion in a stripping liquid or a solvent, for example. At the time of forming the lower superconducting films 11 and 21, and at the time of forming the upper superconducting films 12 and 22, a vapor deposited substance such as aluminum adheres to the mask 110, but the adhered substance is removed along with the removal of the mask 110.

Thereafter, as also illustrated in FIGS. 11 and 19, a mask 120 having an opening 121 is formed on the substrate 50, the lower superconducting film 11, the oxide film 13X, the upper superconducting film 12, the lower superconducting film 21, the oxide film 23X, and the upper superconducting film 22. A region of the substrate 50 for forming the metal film 101 is exposed from the opening 121. In forming the mask 120, a photoresist is applied onto the substrate 50, and then the photoresist is exposed and developed.

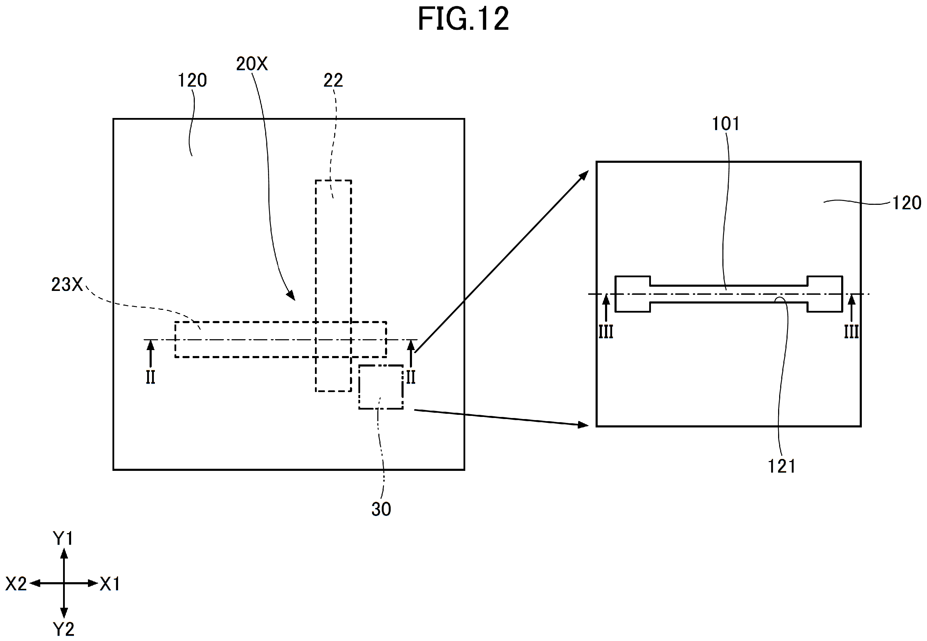

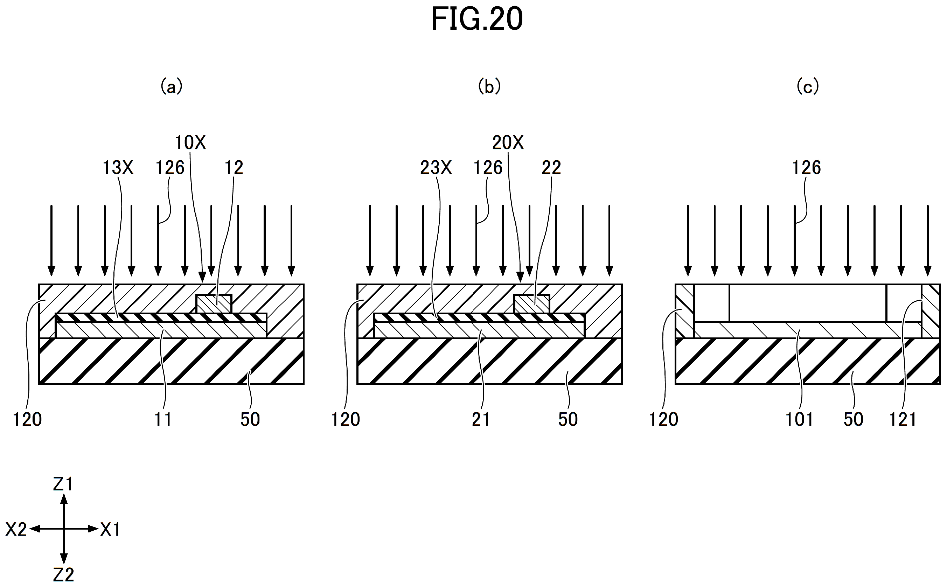

Subsequently, as illustrated in FIGS. 12 and 20, a deposition 126 of a Sn-Pb alloy or a Bi-Sn alloy is performed from the Z1 side of the substrate 50 when viewed from the top surface. As a result, a metal film 101 is formed on the substrate 50 in the opening 121.

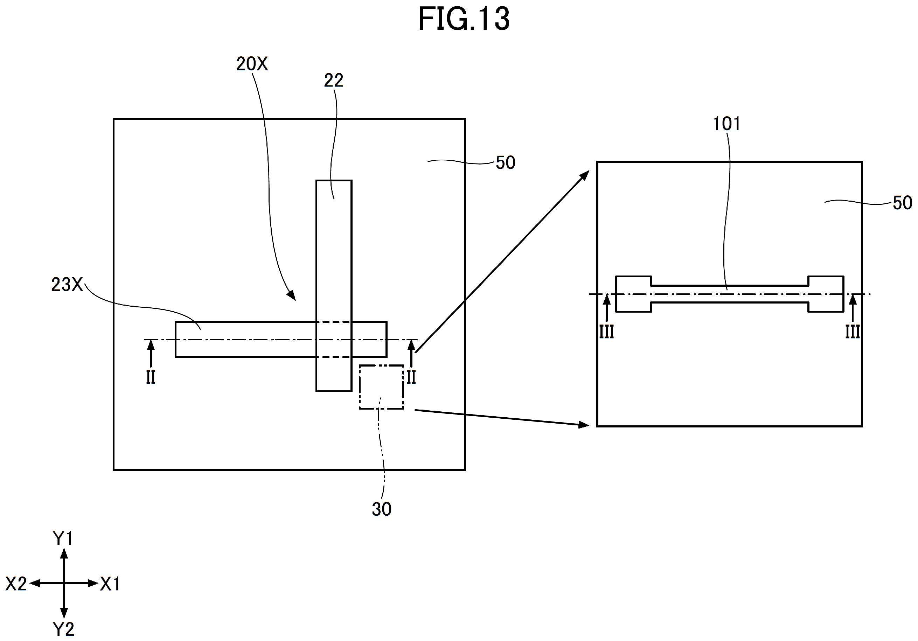

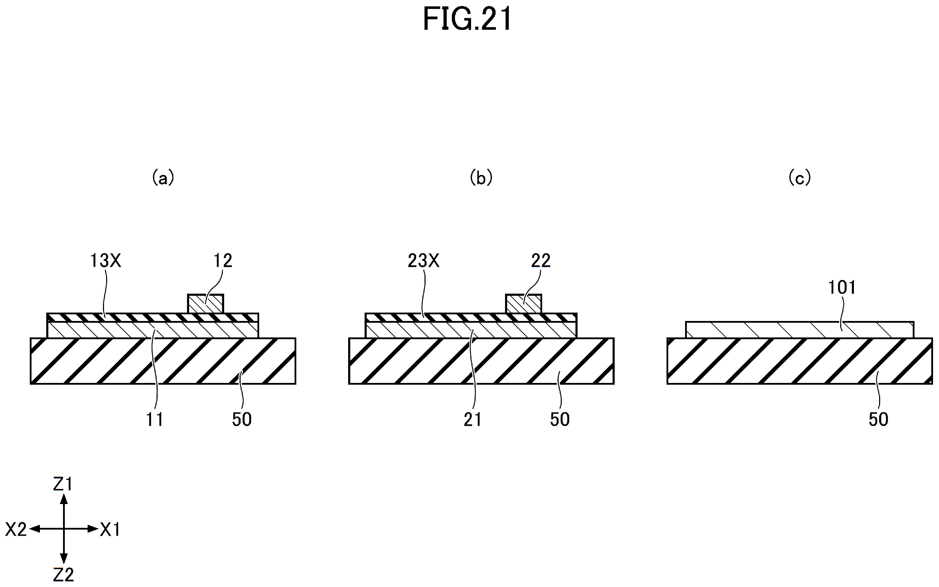

Next, as illustrated in FIGS. 13 and 21, the mask 120 is removed. The mask 120 can be removed, for example, by immersion in a stripping liquid or a solvent. When the metal film 101 is formed, a vapor deposited substance such as a Sn-Pb alloy or a Bi-Sn alloy adheres to the mask 120, but the adhered substance is removed along with the removal of the mask 120.

In this manner, the temporary JJ element 10X to be the Josephson junction element 10, the temporary JJ element 20X to be the Josephson junction element 20, and the metal film 101 can be formed.

Then, the resistance value of the temporary JJ element 20X is measured and recorded (step S2). In the measurement of the resistance value of the temporary JJ element 20X, for example, the resistance value between the lower superconducting film 21 and the upper superconducting film 22 is measured.

Subsequently, the resistance value of the metal film 101 is measured and recorded (step S3). In the measurement of the resistance value of the metal film 101, the resistance value between both ends of the metal film 101 in the X1-X2 direction is measured.

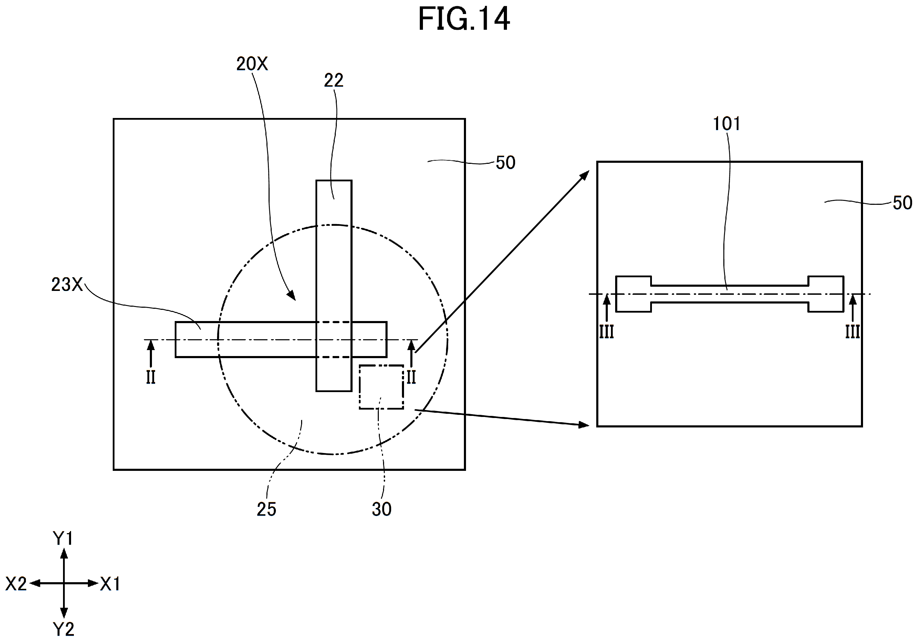

Next, a laser beam is radiated (step S4). Here, the temporary JJ element 10X is irradiated with laser beam, and as illustrated in FIG. 14, the temporary JJ element 20X and the metal film 101 are irradiated with laser beam 25. The laser beam is radiated with power and time based on the resistance value obtained in step S1. Because a table indicating the relationship between the resistance value and the power and time of irradiation with the laser beam is prepared in advance, the power and time can be determined based on the resistance value obtained in step S1.

Thereafter, the temporary JJ element 10X, the temporary JJ element 20X, and the metal film 101 are cooled (step S5). For example, the temporary JJ element 10X, the temporary JJ element 20X, and the metal film 101 are air-cooled to room temperature.

Subsequently, the resistance value of the temporary JJ element 20X is measured and recorded (step S6).

Then, it is determined whether the resistance value obtained in step S6 reaches a predetermined value (step S7). If the resistance value does not reach the predetermined value, the process returns to step S4, and the processes of steps S4 to S7 are repeated until the resistance value of the temporary JJ element 20X reaches the predetermined value.

When the resistance value of the temporary JJ element 20X reaches a predetermined value, the resistance value of the metal film 101 is measured and recorded (step S8).

Thereafter, the resistance value obtained in step S3 is compared with the resistance value obtained in step S8, and based on the result, the temperature reached by the metal film 101 during irradiation with the laser beam is determined (step S9). For example, when the difference between the resistance value obtained in step S3 and the resistance value obtained in step S8 is greater than or equal to a predetermined threshold value, it is determined that the metal film 101 is exposed to a temperature higher than the melting point. Finally, the resistance value with respect to the temporary JJ element 10X may be measured.

Further, by irradiating the oxide film 13X and the oxide film 23X with the laser beam once or a plurality of times, the oxide film 13 and the oxide film 23 adjusted to a desired resistance value can be obtained. In this manner, the quantum device 1 according to the first embodiment including the Josephson junction elements 10 and 20 can be manufactured.

In the present embodiment, the resistance value of the temporary JJ element 20X is measured every time the laser beam is radiated. Therefore, the resistance value of the temporary JJ element 10X can be appropriately adjusted, and Josephson junction elements 10 and 20 having a desired resistance value can be obtained. Further, because the temperature reached by the metal film 101 is determined after the resistance value of the temporary JJ element 20X reaches a predetermined value, the temperature reached by the temporary JJ element 20X at the time of irradiation with the laser beam 25 can be estimated. Further, because irradiation of the temporary JJ element 10X with the laser beam is performed under the same conditions as irradiation of the temporary JJ element 20X with the laser beam, it is also possible to identify a temperature level to which the Josephson junction element 10 has been exposed.

If the deformation of the metal film 101 is remarkable, it may be determined that the metal film 101 has been exposed to a temperature higher than the melting point by visual observation or optical microscope observation instead of measurement of the resistance value.

In the case where a plurality of quantum devices are formed on one substrate (wafer) and the substrate is singulated, it is also conceivable to prepare a reference quantum device without providing the test region 52 and determine the irradiation conditions of the laser beam by using the reference quantum device. However, at a stage before irradiation with the laser beam, the manufacturing variation of the oxide film among a large number of Josephson junction elements in one substrate is large. Therefore, when irradiation with the laser beam is performed by using the conditions determined from the reference quantum device, even if a desired resistance value is obtained for the Josephson junction element in one quantum device, a desired resistance value may be unobtainable for the Josephson junction element in another quantum device.

In the present embodiment, even when a plurality of quantum devices are formed on one substrate and the substrate is singulated, laser beam can be radiated under appropriate conditions for each quantum device. Therefore, a desired resistance value can be obtained for the Josephson junction element in each quantum device.

### (Second Embodiment)

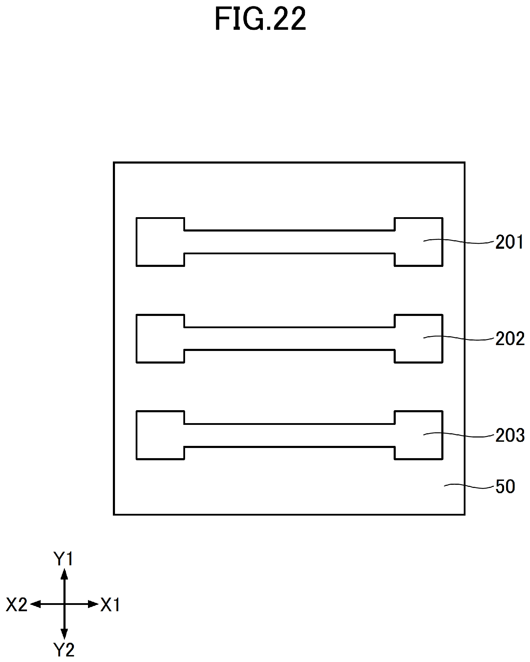

Next, a second embodiment will be described. The second embodiment differs from the first embodiment mainly in the structure of the temperature sensing structure. FIG. 22 is a plan view illustrating the temperature sensing structure included in the quantum device according to the second embodiment.

In the quantum device according to the second embodiment, as illustrated in FIG. 22, the test region 52 has metal films 201, 202, and 203 instead of the metal film 101. The metal films 201, 202, and 203 are provided near the Josephson junction element 20 in a plan view. The metal films 201, 202, and 203 have, for example, the shape of a thin line extending in parallel with the X1-X2 direction. The dimensions (thicknesses) of the metal films 201, 202, and 203 in the Z1-Z2 direction are, for example, 0.1 µm or more and 1.0 µm or less. The dimensions (widths) of the narrowest portions of the metal films 201, 202, and 203 in the Y1-Y2 direction are, for example, 1 µm or more and 10 µm or less. The first distance between each of the metal films 201, 202, and 203 and the Josephson junction element 20 is less than or is equal to the radius of a spot of a laser beam radiated to the Josephson junction element 20, and is, for example, 100 µm or less. The first distance is preferably 80 µm or less, and more preferably 60 µm or less. Here, the first distance between each of the metal films 201, 202, and 203 and the Josephson junction element 20 is a distance between a point of each of the metal films 201, 202, and 203 farthest from the Josephson junction element 20 and a point of the Josephson junction element 20 farthest from each of the metal films 201, 202, and 203.

The metal films 201, 202, and 203 have different melting points. The material of the metal films 201, 202, and 203 is, for example, a Bi-Sn alloy. For example, the melting point of the metal film 201 is 140 °C, the melting point of the metal film 202 is 200 °C, and the melting point of the metal film 203 is 240 °C. Further, for example, the composition of the metal film 201 is 56 mass% Bi-44 mass% Sn, the composition of the metal film 202 is 30 mass% Bi-70 mass% Sn, and the composition of the metal film 203 is 90 mass% Bi-10 mass% Sn. When the laser beam is radiated, the temperatures of the metal films 201, 202, and 203 are approximately equal to the temperature of the temporary JJ element 20X. Therefore, when the temperature of the temporary JJ element 20X becomes higher than the melting point of the metal film 201, 202, or 203 when the laser beam is radiated, the metal film having a temperature higher than the melting point melts and irreversibly deforms. Therefore, the resistance value of the metal film changes. For example, the resistance value between both ends of the metal film in the X1-X2 direction changes. Depending on the degree of deformation, disconnection may occur between both ends of the metal film in the X1-X2 direction. For example, when the temperature of the temporary JJ element 20X reaches 140 °C or more and less than 200 °C, the resistance value of the metal film 201 changes, but the resistance values of the metal films 202 and 203 do not change. Further, when the temperature of the temporary JJ element 20X reaches 200 °C or more and less than 240 °C, the resistance values of the metal films 201 and 202 change, but the resistance value of the metal film 203 does not change. Further, when the temperature of the temporary JJ element 20X reaches 240 °C or more, the resistance values of the metal films 201, 202, and 203 change. The metal film 201 is an example of the first temperature sensing structure, and the metal films 202 and 203 are examples of the second temperature sensing structure.

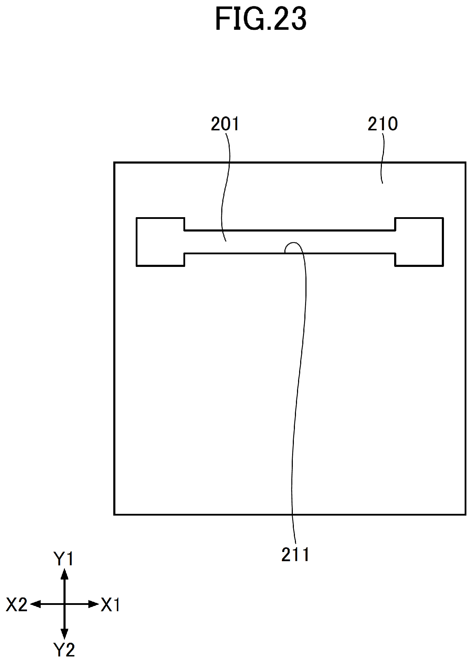

Next, a method of forming the metal films 201, 202, and 203 will be described. FIGS. 23 to 25 are plan diagrams illustrating a method of forming the metal films 201, 202, and 203 in the second embodiment. Here, before forming the metal films 201, 202, and 203, it is assumed that the lower superconducting film 11, the oxide film 14, the upper superconducting film 12, the lower superconducting film 21, the oxide film 24, and the upper superconducting film 22 are formed in the same manner as in the first embodiment.

First, a mask 210 having an opening 211 is formed on the substrate 50, the lower superconducting film 11, the oxide film 14, the upper superconducting film 12, the lower superconducting film 21, the oxide film 24 and the upper superconducting film 22. A region of the substrate 50 in which the metal film 201 is formed is exposed from the opening 211. In forming the mask 210, a photoresist is applied on the substrate 50, and then exposure and development of the photoresist are performed.

Next, as illustrated in FIG. 23, a 56 mass% Bi-44 mass% Sn alloy is evaporated from the Z1 side of the substrate 50 when viewed from the upper surface. As a result, the metal film 201 is formed on the substrate 50 in the opening 211.

Then, the mask 210 is removed. The mask 210 can be removed, for example, by immersion in a stripping liquid or a solvent. At the time of forming the metal film 201, the 56 mass% Bi-44 mass% Sn alloy adheres to the mask 210, but the adherent is removed along with the removal of the mask 210.

Subsequently, a mask 220 having an opening 221 is formed on the substrate 50, the lower superconducting film 11, the oxide film 14, the upper superconducting film 12, the lower superconducting film 21, the oxide film 24, the upper superconducting film 22, and the metal film 201. A region of the substrate 50 for forming the metal film 202 is exposed from the opening 221. In the formation of the mask 220, a photoresist is applied on the substrate 50, and then exposure and development of the photoresist are performed.

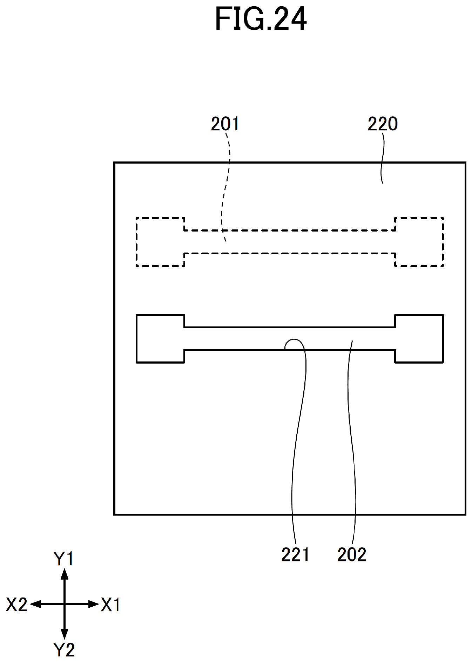

Next, as illustrated in FIG. 24, a 30 mass% Bi-70 mass% Sn alloy is evaporated from the Z1 side of the substrate 50 when viewed from the top surface. As a result, a metal film 202 is formed on the substrate 50 in the opening 221.

Then, the mask 220 is removed. The mask 220 can be removed, for example, by immersion in a stripping liquid or a solvent. When the metal film 202 is formed, a 30 mass% Bi-70 mass% Sn alloy adheres to the mask 220, but the adhered matter is removed along with the removal of the mask 220.

Subsequently, a mask 230 having an opening 231 is formed on the substrate 50, the lower superconducting film 11, the oxide film 14, the upper superconducting film 12, the lower superconducting film 21, the oxide film 24, the upper superconducting film 22, the metal film 201, and the metal film 202. A region of the substrate 50 for forming the metal film 203 is exposed from the opening 231. In the formation of the mask 230, a photoresist is applied on the substrate 50, and then the photoresist is exposed and developed.

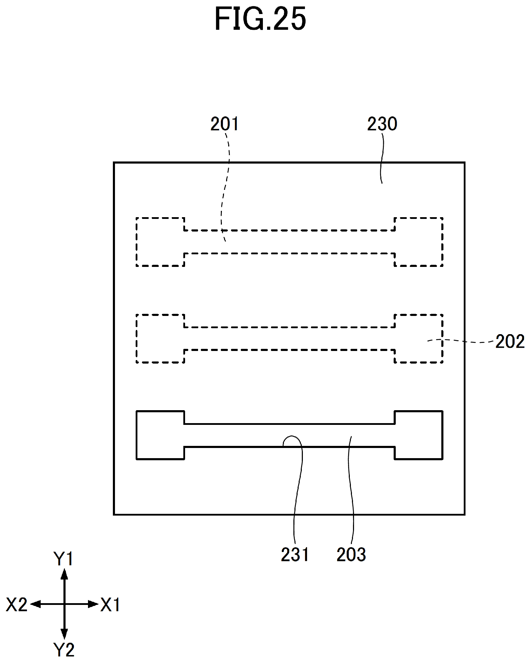

Next, as illustrated in FIG. 25, a 10 mass% Bi-90 mass% Sn alloy is evaporated from the Z1 side of the substrate 50 when viewed from the top surface. As a result, a metal film 203 is formed on the substrate 50 in the opening 231.

Then, the mask 230 is removed. The mask 230 can be removed, for example, by immersion in a stripping liquid or a solvent. At the time of forming the metal film 203, a 10 mass% Bi-90 mass% Sn alloy adheres to the mask 230, but the adhered matter is removed with the removal of the mask 230.

In this way, the metal films 201, 202, and 203 can be formed.

Other configurations of the second embodiment are the same as those of the first embodiment.

The same effects as those of the first embodiment can be obtained by the second embodiment. Further, in the second embodiment, it is not only possible to identify whether or not the temporary JJ elements 10X and 20X have reached a temperature higher than a certain threshold value, but it is also possible to estimate the range of temperatures reached by the temporary JJ elements 10X and 20X. For example, when the resistance value of the metal film 201 changes but the resistance values of the metal films 202 and 203 do not change, it is possible to estimate that the temperatures reached by the temporary JJ elements 10X and 20X are 140 °C or more and less than 200 °C. Further, when the resistance values of the metal films 201 and 202 change but the resistance value of the metal film 203 does not change, it is possible to estimate that the temperatures reached by the temporary JJ elements 10X and 20X are 200 °C or more and less than 240 °C. Further, when the resistance values of the metal films 201, 202, and 203 change, it is possible to estimate that the temperatures reached by the temporary JJ elements 10X and 20X are 240 °C or more.

The material of the metal films 201, 202, and 203 may be a Sn-Pb alloy or the like.

### (Third Embodiment)

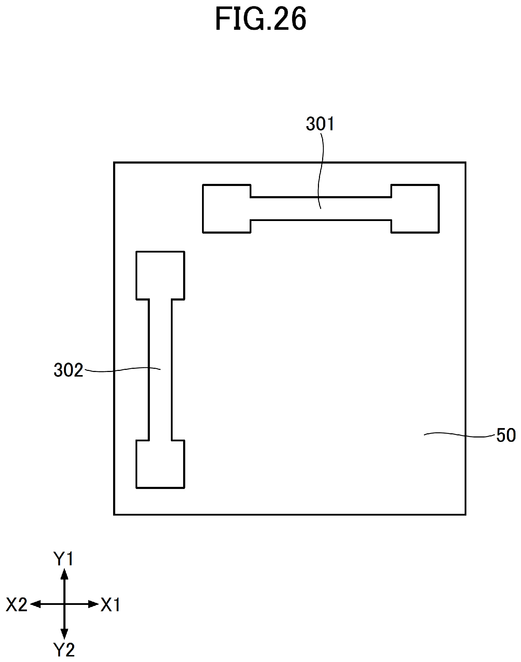

Next, the third embodiment will be described. The third embodiment differs from the first embodiment mainly in the structure of the temperature sensing structure. FIG. 26 is a plan view illustrating the temperature sensing structure included in the quantum device according to the third embodiment.

In the quantum device according to the third embodiment, as illustrated in FIG. 26, the test region 52 has metal films 301 and 302 instead of the metal film 101. The metal films 301 and 302 are provided near the Josephson junction element 20 in a plan view. The metal film 301 has, for example, the shape of a thin line extending in parallel with the X1-X2 direction, and the metal film 302 has, for example, the shape of a thin line extending in parallel with the Y1-Y2 direction. The dimension (thickness) of the metal films 301 and 302 in the Z1-Z2 direction is, for example, 0.1 µm or more and 1.0 µm or less. The dimension (width) of the narrowest portion of the metal film 301 in the Y1-Y2 direction is, for example, 1 µm or more and 10 µm or less, and the dimension (width) of the narrowest portion of the metal film 302 in the X1-X2 direction is, for example, 1 µm or more and 10 µm or less. The first distance between each of the metal films 301 and 302 and the Josephson junction element 20 is less than or is equal to the radius of the spot of the laser beam radiated to the Josephson junction element 20, for example, 100 µm or less. The first distance is preferably 80 µm or less, and more preferably 60 µm or less. Here, the first distance between each of the metal films 301 and 302 and the Josephson junction element 20 is a distance between a point of each of the metal films 301 and 302 farthest from the Josephson junction element 20 and a point of the Josephson junction element 20 farthest from each of the metal films 301 and 302. The X-axis is an example of the first axis, and the Y-axis is an example of the second axis.

The metal films 301 and 302 have different melting points. For example, the melting point of the metal film 301 is 140 °C, and the melting point of the metal film 302 is 200 °C. For example, the metal film 301 is made of the same material as the metal film 201, and the metal film 302 is made of the same material as the metal film 202. The metal film 301 is an example of the first temperature sensing structure, and the metal film 302 is an example of the second temperature sensing structure.

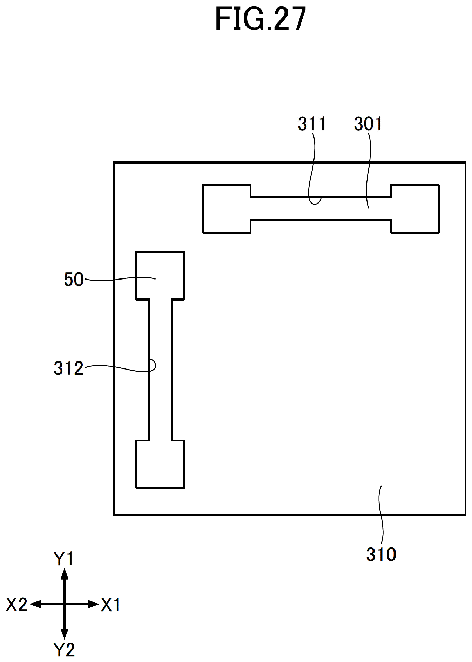

Next, a method of forming the metal films 301 and 302 will be described. FIGS. 27 to 28 are plan diagrams illustrating a method of forming the metal films 301 and 302 in the third embodiment. Here, before forming the metal films 301 and 302, the lower superconducting film 11, the oxide film 14, the upper superconducting film 12, the lower superconducting film 21, the oxide film 24, and the upper superconducting film 22 are formed in the same manner as in the first embodiment.

First, as illustrated in FIG. 27, a mask 310 having openings 311 and 312 is formed on the substrate 50, the lower superconducting film 11, the oxide film 14, the upper superconducting film 12, the lower superconducting film 21, the oxide film 24 and the upper superconducting film 22. A region of the substrate 50 in which the metal film 301 is formed is exposed from the opening 311. A region of the substrate 50 in which the metal film 302 is formed is exposed from the opening 312. In the formation of the mask 310, a photoresist is applied on the substrate 50, and then the photoresist is exposed and developed.

Next, a 56 mass% Bi-44 mass% Sn alloy is evaporated at an angle tilted from the Z1 side toward the X1 or X2 side when viewed from the upper surface of the substrate 50. As a result, a metal film 301 is formed on the substrate 50 in the opening 311.

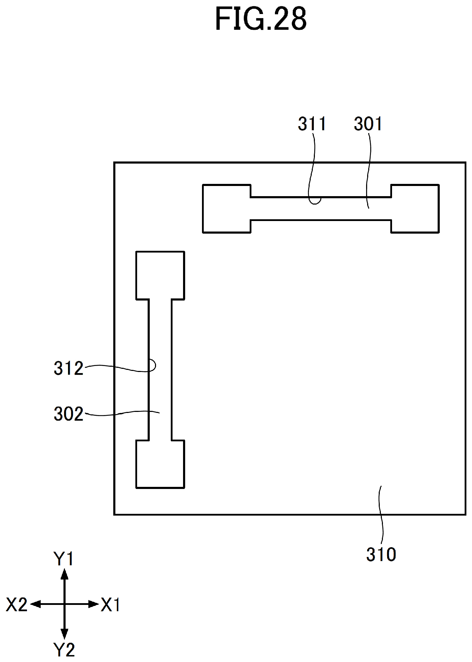

Thereafter, as illustrated in FIG. 28, a 30 mass% Bi-70 mass% Sn alloy is evaporated at an angle tilted from the Z1 side toward the Y1 or Y2 side when viewed from the top surface of the substrate 50. As a result, a metal film 302 is formed on the substrate 50 in the opening 312. The metal film 302 can be formed, for example, in a film formation tank in which the metal film 301 is formed.

Subsequently, the mask 310 is removed. The mask 310 can be removed, for example, by immersion in a stripping liquid or a solvent. At the time of forming the metal film 301 and at the time of forming the metal film 302, the Bi-Sn alloy adheres to the mask 310, but the adhered matter is removed along with the removal of the mask 310.

In this way, the metal films 301 and 302 can be formed.

Other configurations of the third embodiment are the same as those of the first embodiment.

According to the third embodiment, the same effects as those of the first embodiment can be obtained. Further, in the third embodiment, as in the second embodiment, not only can it be determined whether the temporary JJ elements 10X and 20X have reached a temperature equal to or higher than a certain threshold value, but also the range of temperatures reached by the temporary JJ elements 10X and 20X can be estimated.

Further, in the third embodiment, the metal films 301 and 302 can be formed by using one mask 310.

The material of the metal films 301 and 302 may be an Sn-Pb alloy or the like.

### (Fourth Embodiment)

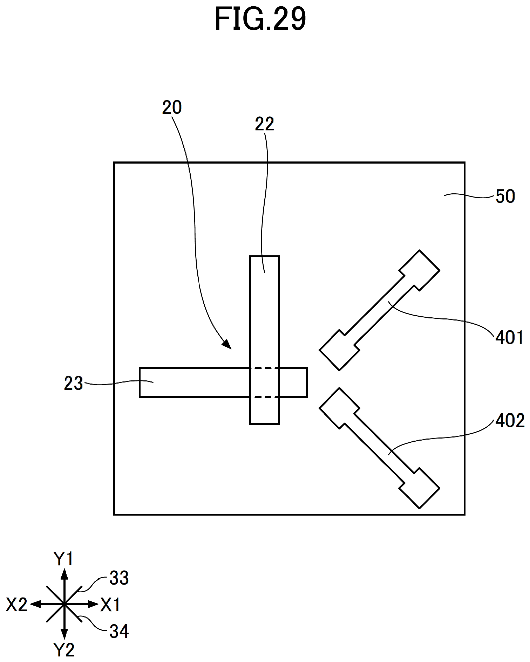

Next, the fourth embodiment will be described. The fourth embodiment differs from the first embodiment mainly in the structure of the temperature sensing structure. FIG. 29 is a plan view illustrating the temperature sensing structure included in the quantum device according to the fourth embodiment.

In the quantum device according to the fourth embodiment, as illustrated in FIG. 29, the test region 52 has metal films 401 and 402 instead of the metal film 101. The metal films 401 and 402 are provided near the Josephson junction element 20 in a plan view. The metal film 401 has, for example, the shape of a thin line extending in parallel to the third axis 33 rotated 45 degrees counterclockwise from the X1-X2 direction, and the metal film 402 has, for example, the shape of a thin line extending in parallel to the fourth axis 34 rotated 45 degrees clockwise from the X1-X2 direction. The dimension (thickness) of the metal films 401 and 402 in the Z1-Z2 direction is, for example, 0.1 µm or more and 1.0 µm or less. The dimension (width) of the narrowest portion of the metal film 401 in the direction parallel to the fourth axis 34 is, for example, 1 µm or more and 10 µm less, and the dimension (width) of the narrowest portion of the metal film 402 in the direction parallel to the third axis 33 is, for example, 1 µm or more and 10 µm or less. The first distance between each of the metal films 401 and 402 and the Josephson junction element 20 is less than or is equal to the radius of the spot of the laser beam radiated to the Josephson junction element 20, and is, for example, 100 µm or less. The first distance is preferably 80 µm or less, and more preferably 60 µm or less. Here, the first distance between each of the metal films 401 and 402 and the Josephson junction element 20 is a distance between a point of each of the metal films 401 and 402 farthest from the Josephson junction element 20 and a point of the Josephson junction element 20 farthest from each of the metal films 401 and 402.

The metal films 401 and 402 have different melting points. For example, the melting point of the metal film 401 is 140 °C, and the melting point of the metal film 402 is 200 °C. For example, the metal film 401 is made of the same material as the metal film 201, and the metal film 402 is made of the same material as the metal film 202. The metal film 401 is an example of the first temperature sensing structure, and the metal film 402 is an example of the second temperature sensing structure.

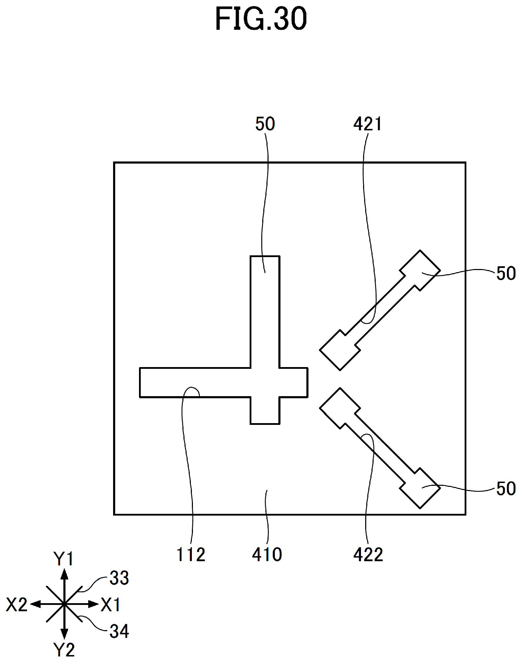

Next, a method of forming the metal films 401 and 402 will be described. FIGS. 30 to 34 are plan diagrams illustrating a method of forming the metal films 401 and 402 in the fourth embodiment. Although partial illustrations are omitted, a method of forming the lower superconducting film 11, the oxide film 14, the upper superconducting film 12, the lower superconducting film 21, the oxide film 24, and the upper superconducting film 22 will be described here.

First, as illustrated in FIG. 30, a mask 410 having openings 111 (see FIG. 15), 112, 421, and 422 is formed on a substrate 50. A region for forming the lower superconducting film 11 and a region for forming the upper superconducting film 12 of the substrate 50 are exposed from the opening 111. A region for forming the lower superconducting film 21 and a region for forming the upper superconducting film 22 of the substrate 50 are exposed from the opening 112. A region for forming the metal film 401 of the substrate 50 is exposed from the opening 421. A region for forming the metal film 402 of the substrate 50 is exposed from the opening 422. In the formation of the mask 410, a photoresist is applied on the substrate 50, and then exposure and development of the photoresist are performed.

Next, aluminum is obliquely deposited at an angle tilted from the Z1 side toward the X2 side as seen from the top surface of the substrate 50. As a result, a lower superconducting film 11 is formed on the substrate 50 in the opening 111, and a lower superconducting film 21 is formed on the substrate 50 in the opening 112 (see FIG. 16). The oblique deposition may be performed from a direction inclined from the Z1 side to the X1 side as seen from the top surface of the substrate 50.

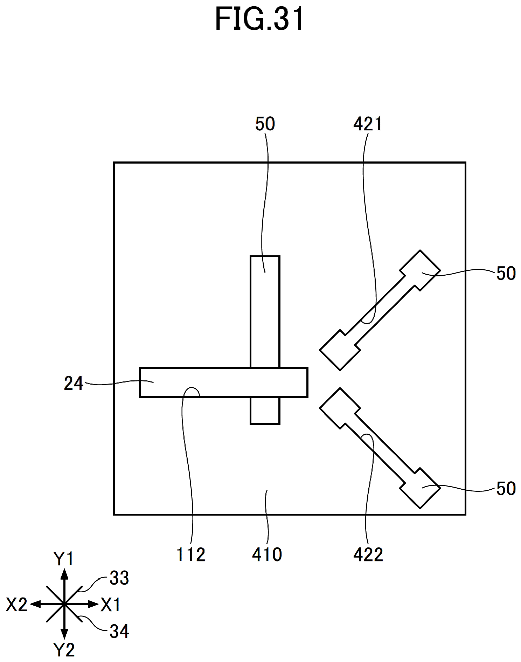

Thereafter, as illustrated in FIG. 31, the top surface of the lower superconducting film 11 and the top surface of the lower superconducting film 21 are oxidized. As a result, an oxide film 14 is formed on the top surface of the lower superconducting film 11 (see FIG. 17), and an oxide film 24 is formed on the top surface of the lower superconducting film 21.

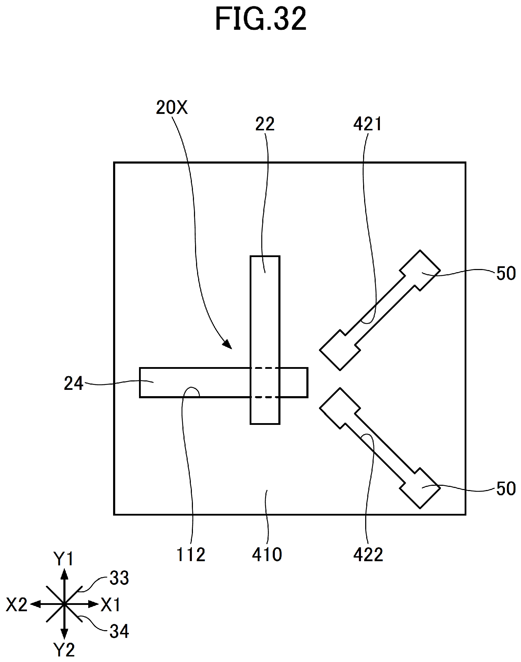

Subsequently, as illustrated in FIG. 32, the oblique deposition of aluminum or niobium is performed at an angle tilted from the Z1 side toward the Y1 side as seen from the top surface of the substrate 50. As a result, an upper superconducting film 12 is formed on the substrate 50 and the oxide film 14 in the opening 111 (see FIG. 18), and an upper superconducting film 22 is formed on the substrate 50 and the oxide film 24 in the opening 112. The oblique deposition may be performed from a direction inclined from the Z1 side to the Y2 side when viewed from the top surface of the substrate 50. The upper superconducting films 12 and 22 may be formed, for example, in a deposition tank in which the oxide films 23 and 24 are formed.

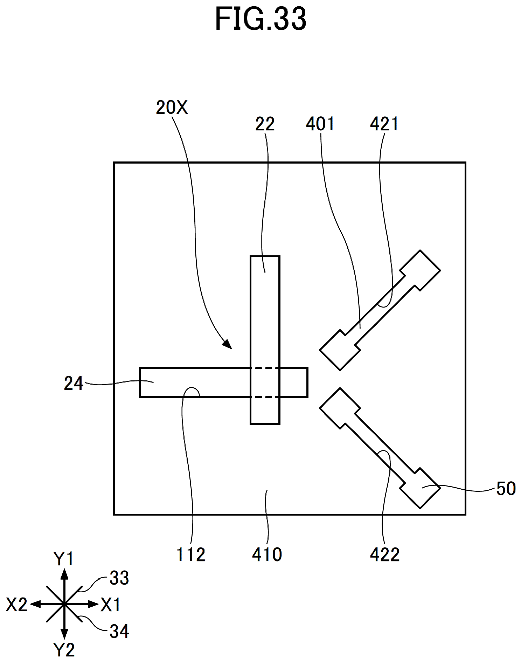

Then, as illustrated in FIG. 33, the 56 mass% Bi-44 mass% Sn alloy is oblique deposited from a direction inclined from the Z1 side to a direction parallel to the third axis 33 when viewed from the top surface of the substrate 50. As a result, the metal film 401 is formed on the substrate 50 in the opening 421. The metal film 401 may be formed, for example, in a deposition tank in which the upper superconducting films 12 and 22 are formed.

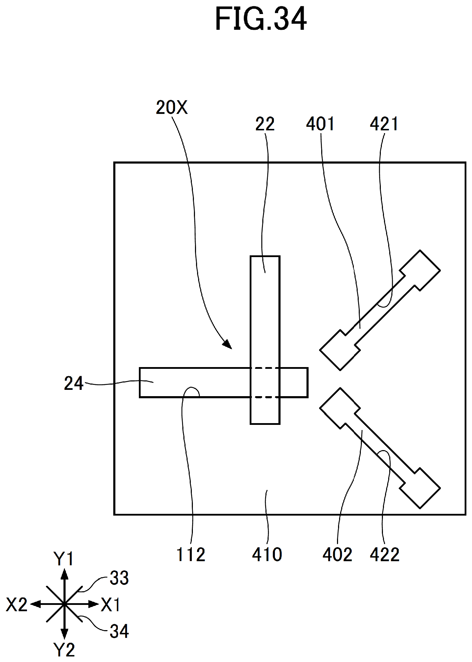

Then, as illustrated in FIG. 34, the 30 mass% Bi-70 mass% Sn alloy is oblique deposited from a direction inclined from the Z1 side to a direction parallel to the fourth axis 34 when viewed from the top surface of the substrate 50. As a result, the metal film 402 is formed on the substrate 50 in the opening 422. The metal film 402 may be formed, for example, in a deposition tank in which the metal film 401 is formed.

Subsequently, the mask 410 is removed. The mask 410 can be removed, for example, by immersion in a stripping liquid or a solvent. A substance deposited during the formation of the lower superconducting films 11 and 21 adheres to the mask 410, but the adhered substance is removed with the removal of the mask 410.

In this way, the metal films 401 and 402 can be formed.

Other configurations of the fourth embodiment are the same as those of the first embodiment.

The fourth embodiment also provides the same effect as that of the first embodiment. Further, in the fourth embodiment, as in the second embodiment, it is possible not only to identify whether or not the temporary JJ elements 10X and 20X have reached a temperature higher than a certain threshold value, but also to estimate the range of temperatures reached by the temporary JJ elements 10X and 20X.

Further, in the fourth embodiment, it is possible to form the lower superconducting films 11 and 21, the upper superconducting films 12 and 22, the oxide films 14 and 24, and the metal films 401 and 402 by using one mask 410.

Note that the material of the metal films 401 and 402 may be a Sn-Pb alloy or the like.

### (Fifth Embodiment)

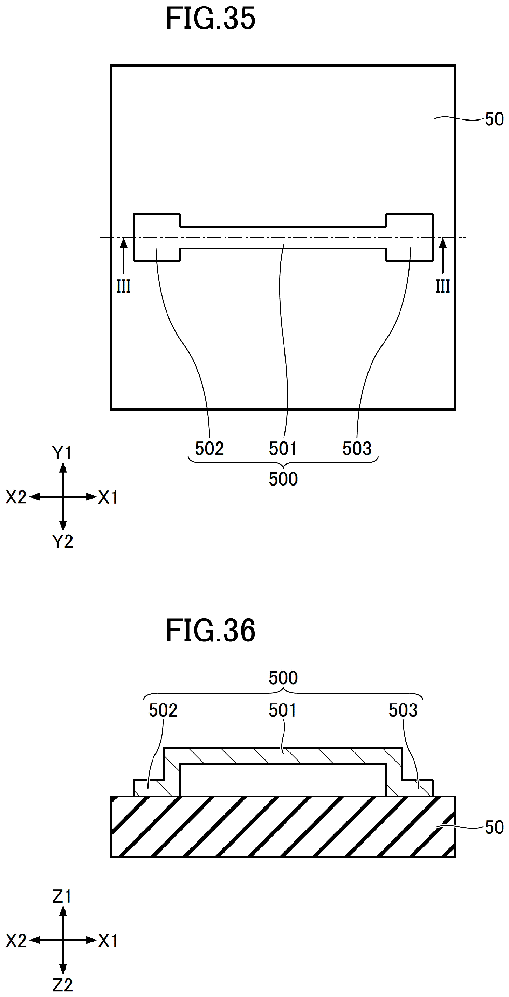

Next, the fifth embodiment will be described. The fifth embodiment differs from the first embodiment mainly in the structure of the temperature sensing structure. FIG. 35 is a plan view illustrating the temperature sensing structure included in the quantum device according to the fourth embodiment. FIG. 36 is a cross-sectional view illustrating a temperature sensing structure included in the quantum device according to the fourth embodiment. FIG. 36 corresponds to a cross-sectional view taken along line III-III in FIG. 35.

In the quantum device according to the fifth embodiment, as illustrated in FIGS. 35 and 36, the test region 52 has a metal film 500 instead of the metal film 101. The metal film 500 is provided near the Josephson junction element 20 in a plan view. The metal film 500 has, for example, the shape of a thin line extending parallel in the X1-X2 direction. The metal film 500 has a beam portion 501 separated from the substrate 50 and support portions 502 and 503 for supporting the beam portion 501 to the substrate 50. The support portion 502 is connected to the X2 side end of the beam portion 501, and the support portion 503 is connected to the X1 side end of the beam portion 501. The dimension (thickness) of the beam portion 501 in the Z1-Z2 direction is, for example, 0.3 µm or more and 1.0 µm or less. The dimension (width) of the narrowest portion of the beam portion 501 in the Y1-Y2 direction is, for example, 1 µm or more and 10 µm or less. The first distance between the beam portion 501 and the Josephson junction element 20 is less than or is equal to the radius of the spot of the laser beam radiated on the Josephson junction element 20, and is, for example, less than or equal to 100 µm. The first distance is preferably less than or equal to 80 µm, and more preferably less than or equal to 60 µm. Here, the first distance between the beam portion 501 and the Josephson junction element 20 is a distance between a point of the beam portion 501 farthest from the Josephson junction element 20 and a point of the Josephson junction element 20 farthest from the beam portion 501.

For example, the metal film 500 is made of the same material as the metal film 101. The metal film 500 is an example of the first temperature sensing structure.

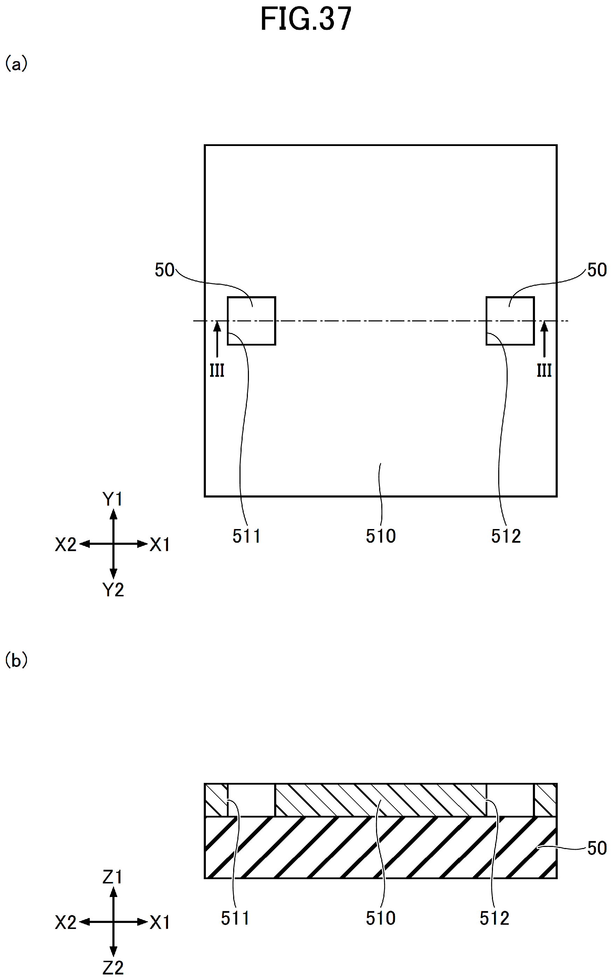

Next, a method of forming the metal film 500 will be described. FIGS. 37 to 39 are diagrams illustrating a method of forming the metal film 500 in the fifth embodiment. FIGS. 37 (a) to 39 (a) are plan views. FIGS. 37 (b) to 39 (b) correspond to cross-sectional views taken along line **III-III** in FIGS. 37 (a) to 39 (a), respectively. Here, before forming the metal film 500, the lower superconducting film 11, the oxide film 14, the upper superconducting film 12, the lower superconducting film 21, the oxide film 24, and the upper superconducting film 22 are formed in the same manner as in the first embodiment.

First, as illustrated in FIG. 37, a mask 510 having openings 511 and 512 is formed on the substrate 50, the lower superconducting film 11, the oxide film 14, the upper superconducting film 12, the lower superconducting film 21, the oxide film 24, and the upper superconducting film 22. A region for forming a support portion 502 of the substrate 50 is exposed from the opening 511. A region for forming a support portion 503 of the substrate 50 is exposed from the opening 512. In the formation of the mask 510, a photoresist is applied on the substrate 50, followed by exposure and development of the photoresist.

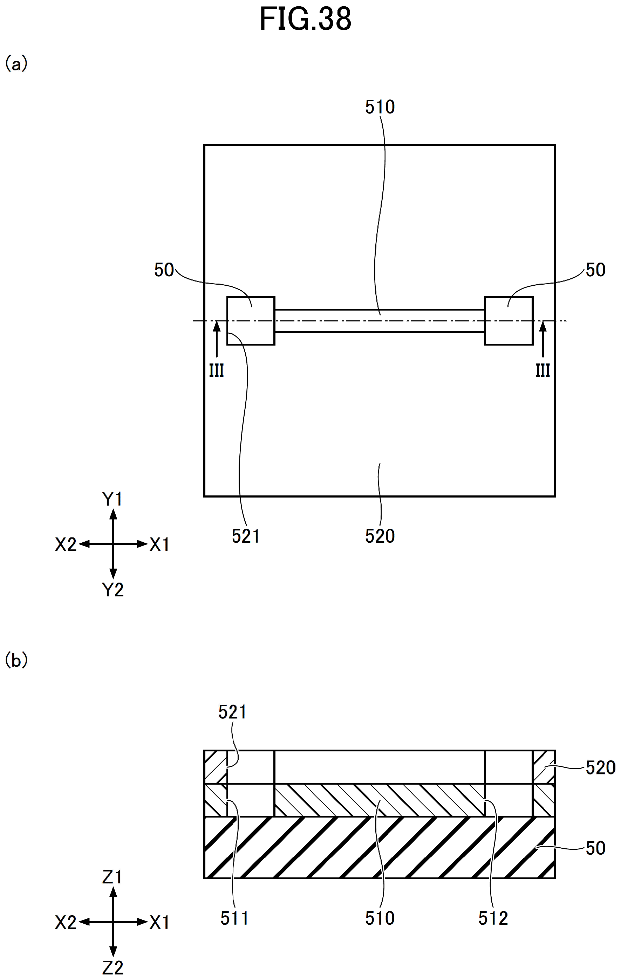

Then, as illustrated in FIG. 38, a mask 520 having an opening 521 is formed on the mask 510. Openings 511 and 512 of the mask 510 and a region for forming a beam portion 501 of the mask 510 are exposed from the opening 521. In forming the mask 520, a photoresist is applied on the mask 510, and then the photoresist is exposed and developed.

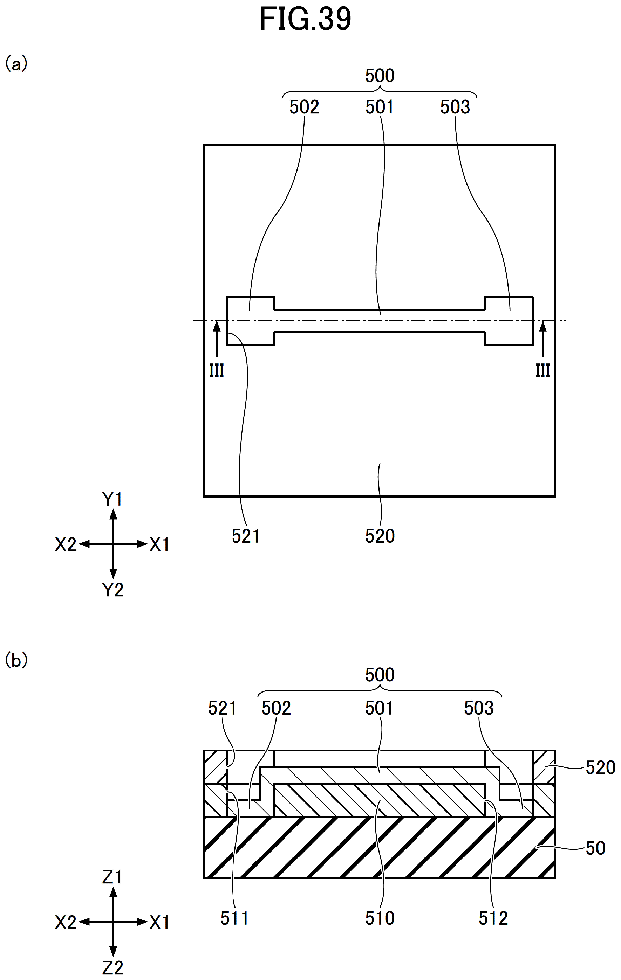

Thereafter, as illustrated in FIG. 39, a Sn-Pb alloy or a Bi-Sn alloy is deposited on the substrate 50. At this time, the oblique deposition may be performed in a direction inclined from the Z1 side to the X2 side or in a direction inclined from the Z1 side to the X1 side. This improves the coverage of the Sn-Pb alloy or the Bi-Sn alloy on the side wall of the mask 510. As a result, a support portion 502 is formed on the substrate 50 in the opening 511, a support portion 503 is formed on the substrate 50 in the opening 512, and a beam portion 501 is formed on the mask 510 in the opening 521.

Subsequently, the mask 510 is removed. The mask 510 can be removed, for example, by immersion in a stripping liquid or a solvent. During the formation of the metal film 500, a vapor deposited material such as a Sn-Pb alloy or a Bi-Sn alloy adheres to the mask 510, but the adhered material is removed along with the removal of the mask 510.

In this way, the metal film 500 can be formed.

Other configurations of the fifth embodiment are the same as those of the first embodiment.

The fifth embodiment also provides the same effects as those of the first embodiment. Further, in the fifth embodiment, because the beam portion 501 of the metal film 500 is separated from the substrate 50, it is easy to deform when heated above the melting point, and the deformation is easy to be visually confirmed.

In the second, third, or fourth embodiments, each metal film may have the same shape as that of the metal film 500.

### (Sixth Embodiment)

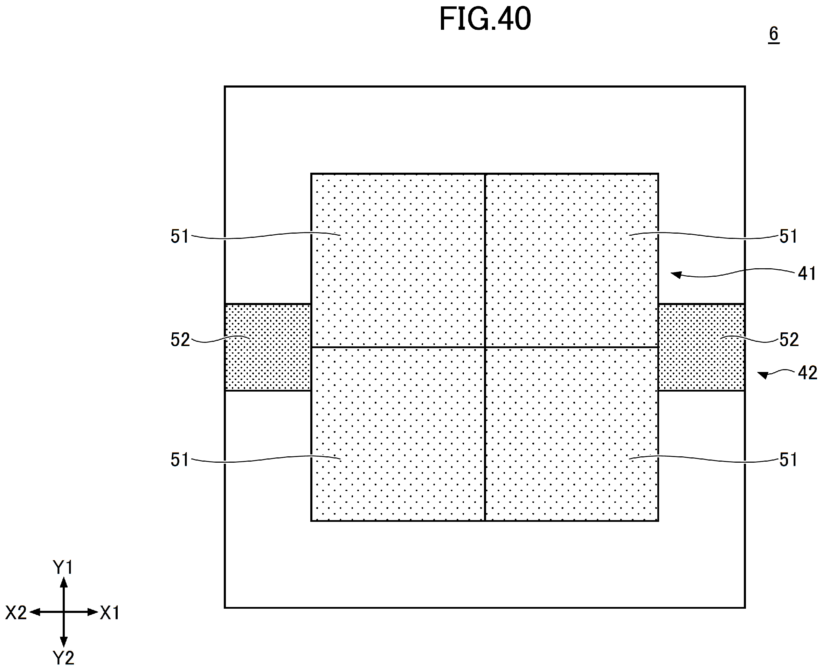

Next, a sixth embodiment will be described. The sixth embodiment differs from the first embodiment mainly in the arrangement of test region. FIG. 40 is a diagram illustrating a layout of a quantum device according to the sixth embodiment.

As illustrated in FIG. 40, in a quantum device 6 according to the sixth embodiment, the peripheral region 42 has a smaller number of test regions than the functional regions 51, in this case, two test regions 52. One test region 52 is arranged adjacent to two functional regions 51 arranged in parallel with the Y1-Y2 direction on the X2 side, and the other test region 52 is arranged adjacent to two functional regions 51 arranged in parallel with the Y1-Y2 direction on the X1 side. Other configurations of the sixth embodiment are the same as those of the first embodiment.

The sixth embodiment also provides the same effects as those of the first embodiment.

### (Seventh Embodiment)

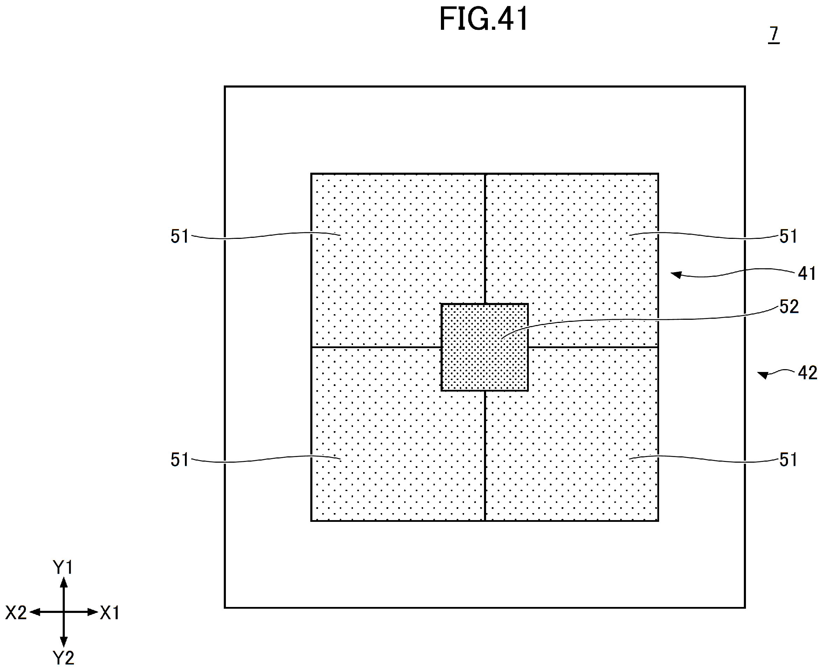

Next, the seventh embodiment will be described. The seventh embodiment differs from the first embodiment mainly in the arrangement of test regions. FIG. 41 is a diagram illustrating a layout of a quantum device according to the seventh embodiment.

As illustrated in FIG. 41, in a quantum device 7 according to the seventh embodiment, one test region 52 is surrounded by four functional regions 51. Other configurations of the seventh embodiment are the same as those of the first embodiment.

The same effects as those of the first embodiment can be obtained by the seventh embodiment.

### (Eighth Embodiment)

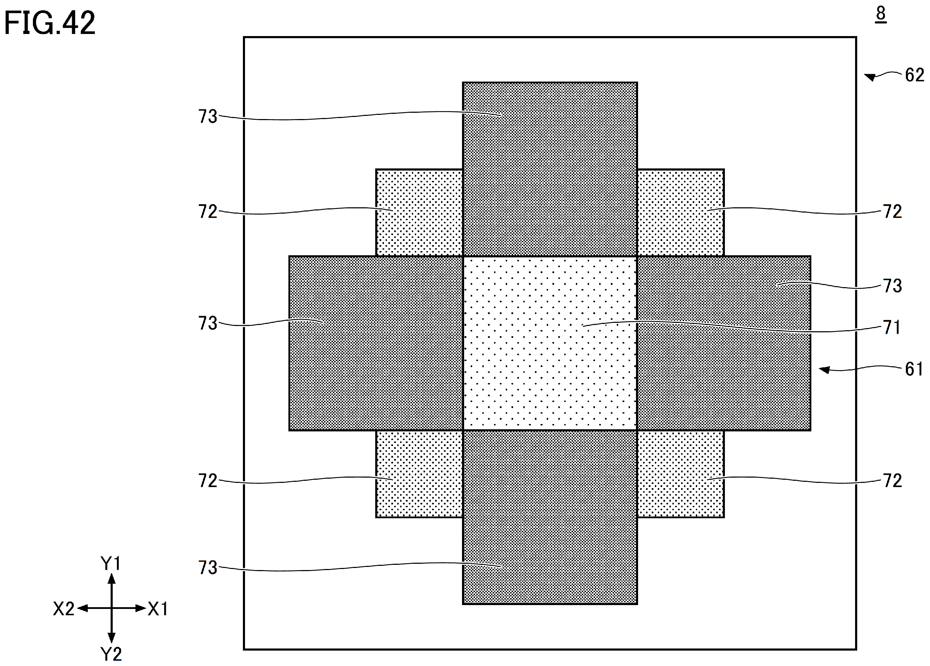

Next, an eighth embodiment will be described. The eighth embodiment relates to a quantum device. FIG. 42 is a diagram illustrating a layout of the quantum device according to the eighth embodiment.

As illustrated in FIG. 42, a quantum device 8 according to the eighth embodiment has a center region 61 and a peripheral region 62. In a plan view, the center region 61 is surrounded by the peripheral region 62. The center region 61 has, for example, one quantum bit region 71 and four auxiliary quantum bit regions 73. The quantum bit region 71 has a square planar shape and has two sides parallel to the X1-X2 direction and two sides parallel to the Y1-Y2 direction. The planar shape of the four auxiliary quantum bit regions 73 is square, and each of them is in contact with one of the sides of the quantum bit region 71. The peripheral region 62 has four test regions 72. The planar shape of the four test regions 72 is square, and each of them is in contact with the two auxiliary quantum bit regions 73.

The quantum bit region 71 and the auxiliary quantum bit region 73 have a Josephson junction element 10 and a capacitor 60 as in the functional region 51. For example, the quantum bit region 71 includes a main quantum bit used for an operation, and the auxiliary quantum bit region 73 includes an auxiliary quantum bit (ancilla) functioning as a temporary memory during an operation. The test region 72 has a Josephson junction element 20 and a metal film 101 as in the test region 52. The Josephson junction element 10 included in the auxiliary quantum bit region 73 is an example of a third Josephson junction element.

According to the eighth embodiment, the same effect as that of the first embodiment can be obtained. Further, the auxiliary quantum bit included in the auxiliary quantum bit region 73 is not required to have quantum performance as high as that of the quantum bit included in the quantum bit region 71. For example, the coherence time of the auxiliary quantum bit included in the auxiliary quantum bit region 73 may be shorter than that of the quantum bit included in the quantum bit region 71 due to irradiation with laser beam.

In the present disclosure, the material of the temperature sensing structure is not limited to metal.

The quantum device according to the present disclosure can be used for quantum computing, for example.

Although the preferred embodiments and the like have been described in detail above, the present disclosure is not limited to the above-described embodiments and the like, and various modifications and substitutions may be added to the above-described embodiments and the like without departing from the scope of the claims.

### REFERENCE SIGNS LIST

1, 6, 7, 8: Quantum device
10, 20: Josephson junction element
10X, 20X: Temporary Josephson junction element
11, 21: Lower superconducting film
12, 22: Upper superconducting film
13, 13X, 23, 23X: Oxide film
25: Laser beam
30: Temperature sensing region
50: Substrate
70: Transmon
101, 201, 202, 203, 301, 302, 401, 402, and 500: metal film
501: beam portion
502 and 503: support portion

## Claims

1. A quantum device comprising:
a first Josephson junction element formed on a substrate;
a second Josephson junction element; and
a first temperature sensing structure, the second Josephson junction element and the first temperature sensing structure being formed in a first region of the substrate, wherein
the first Josephson junction element includes:
a first superconducting film;
a second superconducting film; and
a first oxide film provided between the first superconducting film and the second superconducting film,
the second Josephson junction element includes:
a third superconducting film;
a fourth superconducting film; and
a second oxide film provided between the third superconducting film and the fourth superconducting film, and wherein
the first temperature sensing structure is irreversibly deformed at a first temperature that is lower than a temperature at which a superconducting characteristic of the third superconducting film or the fourth superconducting film changes.

2. The quantum device according to claim 1, wherein the first temperature is 140 °C or more and 190 °C or less.

3. The quantum device according to claim 1 or 2, wherein the first temperature sensing structure includes a first metal film.

4. The quantum device according to claim 3, wherein a material of the first metal film is a tin-lead alloy or a bismuth-tin alloy.

5. The quantum device according to claim 3, wherein
the first metal film includes:
a beam portion separated from the substrate; and
a support portion configured to support the beam portion with respect to the substrate.

6. The quantum device according to claim 1 or 2, wherein the first region includes a second temperature sensing structure that irreversibly deforms at a second temperature that is higher than the first temperature.

7. The quantum device according to claim 6, wherein the second temperature sensing structure includes a second metal film.

8. The quantum device according to claim 1 or 2, wherein
the first temperature sensing structure includes:
a first metal film; and
a second metal film that is irreversibly deformed at a second temperature that is higher than the first temperature, and wherein
in a plan view,
the first metal film extends parallel to a first axis, and
the second metal film extends parallel to a second axis different from the first axis.

9. The quantum device according to claim 8, wherein the first axis and the second axis are orthogonal to each other.

10. The quantum device according to claim 9, wherein, in a plan view, the first superconducting film, the second superconducting film, the third superconducting film, and the fourth superconducting film extend in parallel in a direction inclined by 45 degrees from the first axis or the second axis.

11. The quantum device according to claim 1 or 2, wherein
a material of the first superconducting film is same as a material of the third superconducting film,
a material of the second superconducting film is same as a material of the fourth superconducting film,
a material of the first oxide film is same as a material of the second oxide film, and
a thickness of the second oxide film is 99% or more and 101% or less of a thickness of the first oxide film.

12. The quantum device according to claim 1 or 2, wherein a distance between the first temperature sensing structure and the second Josephson junction element is 100 µm or less.

13. The quantum device according to claim 1 or 2, further comprising:
a circuit including the first Josephson junction element.

14. The quantum device according to claim 1 or 2, further comprising:
a third Josephson junction element bonded to the first Josephson junction element, wherein
the first temperature sensing structure and the second Josephson junction element are arranged closer to the third Josephson junction element than to the first Josephson junction element.

15. A method of manufacturing a quantum device, the method comprising:
simultaneously forming a first superconducting film and a third superconducting film;
simultaneously oxidizing the first superconducting film and the third superconducting film to form a third oxide film on a surface of the first superconducting film and to form a fourth oxide film on a surface of the third superconducting film;
simultaneously forming a second superconducting film sandwiching the third oxide film with the first superconducting film, and a fourth superconducting film sandwiching the fourth oxide film with the third superconducting film;
forming a first temperature sensing structure that is irreversibly deformed at a first temperature that is lower than a temperature at which a superconducting characteristic of the third superconducting film or the fourth superconducting film changes;
irradiating a first Josephson junction element including the first superconducting film, the third oxide film, and the second superconducting film with a first laser beam, and simultaneously irradiating a second Josephson junction element including the third superconducting film, the fourth oxide film, and the fourth superconducting film, and the first temperature sensing structure with a second laser beam; and
confirming presence or absence of deformation of the first temperature sensing structure after the irradiating with the second laser beam, wherein
power and time are equal between the irradiating of the first Josephson junction element with the first laser beam, and the irradiating of the second Josephson junction element and the first temperature sensing structure with the second laser beam.

16. The method of manufacturing the quantum device according to claim 15, wherein the confirming of the presence or absence of the deformation is performed based on a change in electrical resistance.

17. A method of inspecting a quantum device, the quantum device including:
a first temporary Josephson junction element formed on a substrate;
a second temporary Josephson junction element; and
a first temperature sensing structure, the second temporary Josephson junction element and the first temperature sensing structure being formed in a first region of the substrate, wherein
the first temporary Josephson junction element includes:
a first superconducting film;
a second superconducting film; and
a third oxide film provided between the first superconducting film and the second superconducting film,
the second temporary Josephson junction element includes:
a third superconducting film;
a fourth superconducting film; and
a fourth oxide film provided between the third superconducting film and the fourth superconducting film, and wherein
the first temperature sensing structure is irreversibly deformed at a first temperature that is lower than a temperature at which a superconducting characteristic of the third superconducting film or the fourth superconducting film changes, the method comprising:
irradiating the first temporary Josephson junction element with a laser beam to increase a degree of oxidation of the third oxide film, and simultaneously irradiating the second temporary Josephson junction element and the first temperature sensing structure with a laser beam to increase a degree of oxidation of the fourth oxide film; and
confirming presence or absence of deformation of the first temperature sensing structure after the irradiating with the laser beam.

18. The method of inspecting the quantum device according to claim 17, wherein the confirming of the presence or absence of the deformation is performed based on a change in electrical resistance.
